# EUROPEAN PATENT APPLICATION

(11) **EP 4 770 329 A2**
(43) Date of publication of application: **01.07.2026**
(21) Application number: 25209840.5
(22) Date of filing: 20.10.2025
(51) Int. Cl.: H10D 84/01, H10D 30/01, H10D 30/43, H10D 30/00, H10D 30/67, H10D 84/83, H10D 84/85

(54) **SEMICONDUCTOR DEVICE, METHOD OF MANUFACTURING THE SAME, AND ELECTRONIC APPARATUS INCLUDING THE SAME**

(30) Priority: 24.12.2024 KR 20240196098
(71) Applicant: Samsung Electronics Co., Ltd., Suwon-si, Gyeonggi-do 16677 (KR)
(72) Inventor: KIM, Deokhwan, 16677 Suwon-si (KR); KIM, Sungmin, 16677 Suwon-si (KR); KIM, Jaemyeong, 16677 Suwon-si (KR); KIM, Jeonggeol, 16677 Suwon-si (KR); LEE, Yongkyung, 16677 Suwon-si (KR)
(74) Representative: Elkington and Fife LLP

(57) **Abstract**

A semiconductor device may include an active semiconductor layer, a gate insulating film surrounding at least three surfaces of the active semiconductor layer, a gate electrode extending in a first direction and surrounding at least three surfaces of the gate insulating film. The gate electrode may be separated from another gate electrode or another electronic device by a gate cut having a shape of a trench to electrically isolate the gate electrode from the other gate electrode or the other electronic device. The gate cut may face the gate electrode in a second direction. The second direction may be perpendicular to the first direction. The gate insulating film may extend to a sidewall of the gate cut along a lower surface of the gate electrode.

## Description

### FIELD OF THE INVENTION

The disclosure relates to semiconductor devices, methods of manufacturing semiconductor devices, and/or electronic apparatuses including semiconductor devices.

### BACKGROUND OF THE INVENTION

A field effect transistor (FET) is a semiconductor device that performs an electrical switching function and may be used in various integrated circuit devices, including memory, driver integrated circuits (ICs), and logic devices, etc. As the integration density of integrated circuit devices increases, the size of a FET within integrated circuit devices is also rapidly shrinking. As the size of FET decreases, a fin FET (FinFET) and a gate-all-around FET (GAAFET), etc. are being proposed to address the issue of reducing of a channel area. These FinFET, GAAFET, etc. may each include gate structures having relatively high aspect ratios, so the level of difficulty of the manufacturing process thereof may be high.

### SUMMARY OF THE INVENTION

Provided are semiconductor devices, methods of manufacturing semiconductor devices, and/or electronic apparatuses including semiconductor devices.

Additional aspects will be set forth in part in the description which follows and, in part, will be apparent from the description, or may be learned by practice of the presented embodiments of the disclosure.

According to an embodiment of the disclosure, a semiconductor device may include an active semiconductor layer; a gate insulating film surrounding at least three surfaces of the active semiconductor layer; and a gate electrode extending in a first direction and surrounding at least three surfaces of the gate insulating film. The gate electrode may be separated from another gate electrode or another electronic device by a gate cut having a shape of a trench to electrically isolate the gate electrode from the other gate electrode or the other electronic device. The gate cut may face the gate electrode in a second direction. The second direction may be perpendicular to the first direction. The gate insulating film may extend to a sidewall of the gate cut along a lower surface of the gate electrode.

In some embodiments, the semiconductor device may further include an isolation film including an insulating dielectric material. The active semiconductor layer may extend in the first direction to protrude over the isolation film in the first direction.

In some embodiments, a first portion of the gate electrode may extend along a surface of the active semiconductor layer from an upper surface of the isolation film to surround the active semiconductor layer, a second portion of the gate electrode may extend in the second direction on the upper surface of the isolation film, a first part of the gate insulating film may be between the active semiconductor layer and the first portion of the gate electrode, and a second part of the gate insulating film is between the upper surface of the isolation film and the second portion of the gate electrode.

In some embodiments, a third part of the gate insulating film may extend to an outer surface of the gate electrode opposite to the active semiconductor layer through the sidewall of the gate cut. The first part, the second part, and the third part of the gate insulating film may extend continuously.

In some embodiments, an end portion of the second portion of the gate electrode may match a position of the gate cut.

In some embodiments, the gate cut may have the shape of the trench provided in an upper surface of the isolation film, a bottom surface of the gate cut may further protrude in the first direction from the upper surface of the isolation film adjacent to the gate cut in a third direction, and the third direction may be perpendicular to the first direction and the second direction.

In some embodiments, the semiconductor device may further include a gate connection portion. The active semiconductor layer may include a first active semiconductor layer and a second active semiconductor layer adjacent to each other in the second direction. The gate electrode may include a first gate electrode surrounding at least three surfaces of the first active semiconductor layer and a second gate electrode surrounding at least three surfaces of the second active semiconductor layer. The gate connection portion may be between the first gate electrode and the second gate electrode.

In some embodiments, the first gate electrode, the second gate electrode, and the gate connection portion may be formed integrally from a single conductive material.

In some embodiments, the gate connection portion may include a conductive material having a greater electrical conductivity than a material of the first gate electrode and a material of the second gate electrode.

In some embodiments, the gate insulating film may surround at least three surfaces of the first active semiconductor layer between the first active semiconductor layer and the first gate electrode, and the gate insulating film may surround at least three surfaces of the second active semiconductor layer between the second active semiconductor layer and the second gate electrode.

In some embodiments, the gate insulating film may extend along the first gate electrode, the gate connection portion, and the second gate electrode.

In some embodiments, the gate insulating film may surround a lower surface of the gate connection portion, an upper surface of the gate connection portion, and both side surfaces of the gate connection portion in a third direction, and the third direction may be perpendicular to the first direction and the second direction.

In some embodiments, the gate connection portion may include a first gate connection portion adjacent to the first gate electrode and a second gate connection portion adjacent to the second gate electrode. A thickness of the first gate connection portion in the first direction may be different from a thickness of the second gate connection portion in the first direction.

In some embodiments, each of the first gate electrode and the second gate electrode may include a first gate layer and a second gate layer surrounded by the first gate layer. The first gate connection portion and the second gate connection portion each may include a first connection layer and a second connection layer surrounded by the first connection layer. The first gate layer of the first gate electrode, the first gate layer of the second gate electrode, the first connection layer of the first gate connection portion, and the first connection layer of the second gate connection portion each may include a first conductive material. The second gate layer of the first gate electrode, the second gate layer of the second gate electrode, the second connection layer of the first gate connection portion, and the second connection layer of the second gate connection portion each may include a second conductive material. The second conductive material may be different from the first conductive material. A thickness of the first connection layer of the first gate connection portion may be equal to a thickness of the first connection layer of the second gate connection portion. The thickness of the second connection layer of the first gate connection portion in the first direction may be different from the thickness of the second connection layer of the second gate connection portion in the first direction.

In some embodiments, the semiconductor device may further include an insulating filler covering the gate connection between the first gate electrode and the second gate electrode, a conductive filler on the insulating filler between the first gate electrode and the second gate electrode, and a gate contact contacting an upper surface of the conductive filler.

In some embodiments, the semiconductor device may further include a conductive filler covering the gate connection between the first gate electrode and the second gate electrode, and a gate contact contacting an upper surface of the conductive filler.

In some embodiments, a first portion of the gate insulating film may surround four surfaces of the active semiconductor layer, and a second portion of the gate insulating film may extend to the sidewall of the gate cut along a lower surface of the gate electrode in the second direction. The first portion of the gate insulating film may be separated from the second portion of the gate insulating film, and the gate electrode may surround four surfaces of the first portion of the gate insulating film.

In some embodiments, the active semiconductor layer may include a plurality of channel elements spaced apart from each other in the first direction. The first portion of the gate insulating film may surround surfaces of each of the plurality of channel elements.

According to an example embodiment of the disclosure, a method of manufacturing a semiconductor device may include forming an active semiconductor layer that protrudes and extends in a first direction from a substrate; forming an isolation film covering an upper surface of the substrate and a side surface of the active semiconductor layer; conformally forming a dummy gate along a surface of the isolation film; by partially etching the isolation film, forming a trench adjacent to the active semiconductor layer in a second direction, the second direction being perpendicular to the first direction, the trench extending in a third direction, the third direction being perpendicular to the first direction and the second direction; forming a dummy block, the dummy block covering the trench and the active semiconductor layer; removing the isolation film on side surfaces of the dummy gate and the active semiconductor layer to expose the active semiconductor layer and form an empty space in the dummy block; conformally forming a gate insulating film along an inner surface of the dummy block and the side surface of the active semiconductor layer; forming a gate electrode, by filling a remaining portion of the empty space in the dummy block, which remains after the gate insulating film is formed, with a conductive material; and removing the dummy block.

According to an example embodiment of the disclosure, an electronic apparatus may include a memory; and a memory controller configured to control the memory to read data from the memory and/or write data to the memory. At least one of the memory and the memory controller may include a semiconductor device. The semiconductor device may include an active semiconductor layer, a gate insulating film surrounding at least three surfaces of the active semiconductor layer, a gate electrode extending in a first direction and surrounding at least three surfaces of the gate insulating film, and a gate cut. The gate electrode may be separated from another gate electrode or another electronic device. The gate cut may have a shape of a trench to electrically isolate the gate electrode from the other gate electrode or the other electronic device. The gate cut may face the gate electrode in a second direction, and the second direction may be perpendicular to the first direction. The gate insulating film may extend to a sidewall of the gate cut along a lower surface of the gate electrode.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 schematically illustrates a structure of a semiconductor device according to an embodiment;
FIG. 2 illustrates a vertical cross-sectional structure of the semiconductor device taken along line A1-A1' of FIG. 1;
FIG. 3 illustrates a vertical cross-sectional structure of the semiconductor device taken along line A2-A2' of FIG. 1;
FIG. 4 illustrates a horizontal cross-sectional structure of the semiconductor device taken along line A3-A3' of FIG. 1;
FIG. 5 schematically illustrates a structure of a semiconductor device according to another embodiment;
FIG. 6 schematically illustrates a structure of a semiconductor device according to another embodiment;
FIG. 7 illustrates a vertical cross-sectional structure of the semiconductor device taken along line B1-B1' of FIG. 6;
FIG. 8 schematically illustrates a structure of a semiconductor device according to another embodiment;
FIG. 9 schematically illustrates a structure of a semiconductor device according to another embodiment;
FIGS. 10A to 10S schematically illustrate a method of manufacturing a semiconductor device, according to an embodiment;
FIG. 11 schematically illustrates a structure of a semiconductor device according to another embodiment;
FIG. 12 schematically illustrates a structure of a semiconductor device according to another embodiment;
FIG. 13 schematically illustrates a structure of a semiconductor device according to another embodiment;
FIG. 14 schematically illustrates a structure of a semiconductor device according to another embodiment;
FIG. 15 schematically illustrates a structure of a semiconductor device according to another embodiment;
FIGS. 16A to 16C schematically illustrate a method of forming a gate connection portion including a conductive material different from materials of a first gate electrode and a second gate electrode;
FIG. 17 illustrates a circuit diagram of a complementary metal oxide semiconductor (CMOS) inverter according to an embodiment;
FIG. 18 illustrates a circuit diagram of a CMOS static random access memory (SRAM) device according to an embodiment;
FIG. 19 illustrates a block diagram showing an electronic apparatus according to an embodiment; and
FIG. 20 is a block diagram of an electronic apparatus according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, with reference to the attached drawings, a semiconductor device, a method of manufacturing the semiconductor device, and an electronic apparatus including the semiconductor device are described in detail. In the attached drawings, the same reference numerals refer to the same components, and the size of each component in the drawings may be exaggerated for clarity and convenience of description. In addition, various embodiments described below are merely examples, and various modifications may be made for the embodiments.

Hereinafter, the terms "upper", "lower", "left", or "right" may include not only being located above/below/left/right while being in direct contact, but also being located above/below/left/right without being in contact. Singular expressions include plural expressions unless the context clearly indicates otherwise. Additionally, when a part is described to "include" a component, this does not mean that the part excludes other components, but rather means that the part may further include other components, unless otherwise specifically described.

The use of the article "the" and similar referential terms to indicate a referent may refer to both singular and plural referents. Unless operations of a method are explicitly described in a specific order or to the contrary, these operations may be performed in any suitable order and are not necessarily limited to the order described.

Additionally, terms such as "~unit", "module", etc. described in the specification mean a unit that processes at least one function or operation, which may be implemented by hardware or software, or a combination of hardware and software.

Connections of lines between components depicted in the drawings or connection members are merely illustrative of functional connections and/or physical or circuit connections, and in an actual device, may be represented as alternative or additional various functional connections, physical connections, or circuit connections.

Any use of examples or terms thereof is merely intended to elaborate technical ideas and is not intended to limit the scope of the invention unless otherwise defined by the claims.

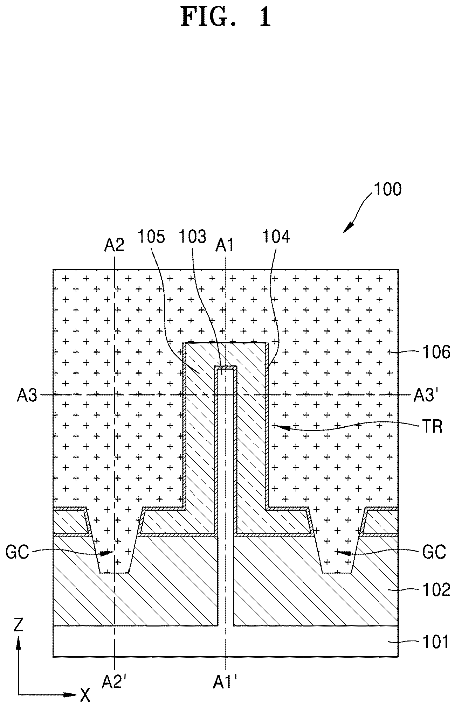

FIG. 1 schematically illustrates a structure of a semiconductor device according to an embodiment. Referring to FIG. 1, a semiconductor device 100 may include a substrate 101, an active semiconductor layer 103 protruding in a vertical direction (e.g., in a first direction or in a Z-axis direction) from an upper surface of the substrate 101, a gate insulating film 104 surrounding a surface of the active semiconductor layer 103, and a gate electrode 105 surrounding a surface of the gate insulating film 104. The gate insulating film 104 and the gate electrode 105 may be provided to extend along the surface of the active semiconductor layer 103 so as to surround a first surface and a second surface of the active semiconductor layer 103 and an upper surface of the active semiconductor layer 103, wherein the first surface and the second surface of the active semiconductor layer 103 face each other in a horizontal direction (that is, in a second direction or in an X-axis direction). The gate insulating film 104 may be provided between the active semiconductor layer 103 and the gate electrode 105 so that the active semiconductor layer 103 does not directly contact the gate electrode 105. Accordingly, the gate insulating film 104 may surround three surfaces of the active semiconductor layer 103, and the gate electrode 105 may surround three surfaces of the gate insulating film 104.

The substrate 101 may include a semiconductor substrate. For example, the substrate 101 may include at least one semiconductor material of a group IV semiconductor such as silicon (Si) or germanium (Ge), a group III-V compound semiconductor such as GaAs or GaP, and an oxide semiconductor. The substrate 101 may include a bulk semiconductor substrate or a silicon on insulator (SOI) substrate.

Additionally, the semiconductor device 100 may further include a first passivation layer 106 provided to cover the gate insulating film 104 and the gate electrode 105. The first passivation layer 106 may be provided to fill a space surrounding the gate insulating film 104 and the gate electrode 105 in the second direction. The first passivation layer 106 may include an insulating dielectric material.

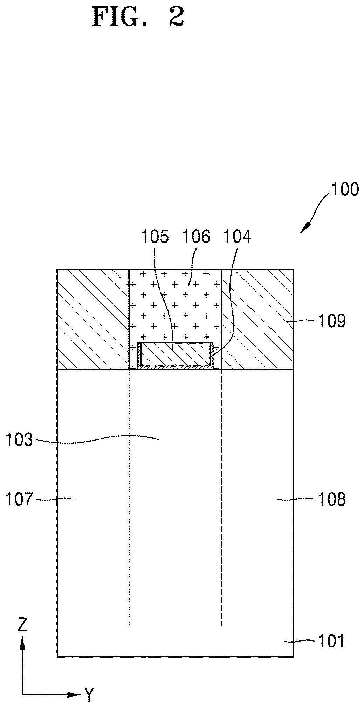

FIG. 2 illustrates a vertical cross-sectional structure of the semiconductor device 100 taken along line A1-A1' of FIG. 1. In other words, FIG. 2 illustrates a cross-section taken by cutting a portion of the active semiconductor layer 103 of the semiconductor device 100. Referring to FIG. 2, the semiconductor device 100 may further include a source region 107 and a drain region 108 provided on a first side and a second side of the active semiconductor layer 103, respectively, wherein the first side and the second side face each other in a third direction (e.g., in a Y-axis direction) perpendicular to the first and second directions. Additionally, the semiconductor device 100 may further include a second passivation layer 109 provided to cover the source region 107 and the drain region 108. The second passivation layer 109 may be provided to fill a space above the source region 107 and the drain region 108 in the second direction. The second passivation layer 109 may include an insulating dielectric material.

The active semiconductor layer 103 may be between the source region 107 and the drain region 108 in the third direction. The active semiconductor layer 103, the source region 107, and the drain region 108 may have a rod shape that protrudes from the substrate 101 in the first direction and extends in the third direction. The active semiconductor layer 103, the source region 107, and the drain region 108 may include at least one semiconductor material of a group IV semiconductor such as Si or Ge, a group III-V compound semiconductor such as GaAs or GaP, an oxide semiconductor, and a two-dimensional material semiconductor, for example. The active semiconductor layer 103 may be doped with a first conductivity type impurity, and the source region 107 and the drain region 108 may be doped with a second conductivity type impurity that is electrically opposite to the first conductivity type impurity. For example, the active semiconductor layer 103 may include a p-type semiconductor, and the source region 107 and the drain region 108 may include an n-type semiconductor. As another example, the active semiconductor layer 103 may include an n-type semiconductor, and the source region 107 and the drain region 108 may include a p-type semiconductor. The active semiconductor layer 103 may be doped at a relatively low concentration of about 10¹⁶/cm³ to about 10¹⁷/cm³, and the source region 107 and the drain region 108 may be doped at a relatively high concentration of about 10¹⁹/cm³ to about 10²¹/cm³.

The active semiconductor layer 103, the source region 107, the drain region 108, the gate insulating film 104, and the gate electrode 105 may form one field effect transistor TR. In particular, the field effect transistor TR illustrated in FIGS. 1 and 2 may be a FinFET. Accordingly, the semiconductor device 100 may include the field effect transistor TR. In FIGS. 1 and 2, the semiconductor device 100 is illustrated as including one field effect transistor TR, but the semiconductor device 100 may include two or more field effect transistors TR.

Referring again to FIG. 1, the semiconductor device 100 may further include an isolation film 102 electrically isolating adjacent field effect transistors TR from each other. The isolation film 102 may include an insulating dielectric material and may be provided on the upper surface of the substrate 101. The active semiconductor layer 103 may extend from the substrate 101 in the first direction to penetrate the isolation film 102 and protrude over the isolation film 102. The source region 107 and the drain region 108 illustrated in FIG. 2 may also extend from the substrate 101 in the first direction to penetrate the isolation film 102 and protrude over the isolation film 102.

The gate insulating film 104 and the gate electrode 105 may be provided on an upper surface of the isolation film 102. The gate insulating film 104 may include a first portion protruding in the first direction from the upper surface of the isolation film 102, and a second portion extending in the second direction on the upper surface of the isolation film 102. The gate electrode 105 may also include a first portion protruding in the first direction from the upper surface of the isolation film 102, and a second portion extending in the second direction on the upper surface of the isolation film 102. The first portion of the gate insulating film 104 and the first portion of the gate electrode 105 may extend along surfaces of the active semiconductor layer 103 from the upper surface of the isolation film 102 in the first direction, to surround the active semiconductor layer 103 protruding from the isolation film 102 in the first direction. The first portion of the gate insulating film 104 may be provided between the active semiconductor layer 103 and the first portion of the gate electrode 105, and the second portion of the gate insulating film 104 may be provided between the upper surface of the isolation film 102 and the second portion of the gate electrode 105.

The semiconductor device 100 may also further include a gate cut GC to electrically or signally isolate the gate electrode 105 of the field effect transistor TR from gate electrodes of other adjacent field effect transistors or from other adjacent electronic devices. The gate cut GC may have a shape of a concave groove or trench, for example, that is formed by partially etching the upper surface of the isolation film 102. The gate cut GC may be provided to face and be adjacent to the gate electrode 105 in the second direction. In FIG. 1, the gate cut GC is illustrated as having an inclined sidewall provided within the isolation film 102, but is not limited thereto, and the gate cut GC may have a vertical sidewall. In addition, FIG. 1 illustrates that gate cuts GC are provided on both sides of the field effect transistor TR in the second direction, but are not limited thereto. Depending on electrical or signal needs, the gate cut GC may be provided on only one side of the field effect transistor TR in the second direction, or gate cuts GC may not exist on both sides of the field effect transistor TR.

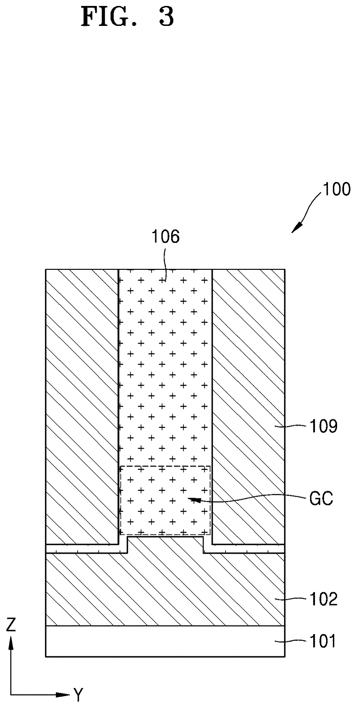

FIG. 3 illustrates a vertical cross-sectional structure of the semiconductor device 100 taken along line A2-A2' of FIG. 1. In other words, FIG. 3 illustrates a cross-section of a portion of the gate cut GC of the semiconductor device 100, by cutting the gate cut GC into a plane parallel to the first direction and the third direction. Referring to FIG. 3, the gate cut GC may be filled with the first passivation layer 106 provided to cover the gate insulating film 104 and the gate electrode 105. The second passivation layer 109 that covers the source region 107 and the drain region 108 may be provided on both sides of the first passivation layer 106 in the third direction. A portion of the first passivation layer 106 may extend to a periphery of the gate cut GC in the third direction. Therefore, the second passivation layer 109 may not directly contact the isolation film 102, and the first passivation layer 106 may be disposed between the isolation film 102 and the second passivation layer 109. On the other hand, in FIG. 3, the first passivation layer 106 and the second passivation layer 109 are shown as being distinguishable from each other for convenience, but when the first passivation layer 106 and the second passivation layer 109 include the same material, the first passivation layer 106 and the second passivation layer 109 may not be distinguished.

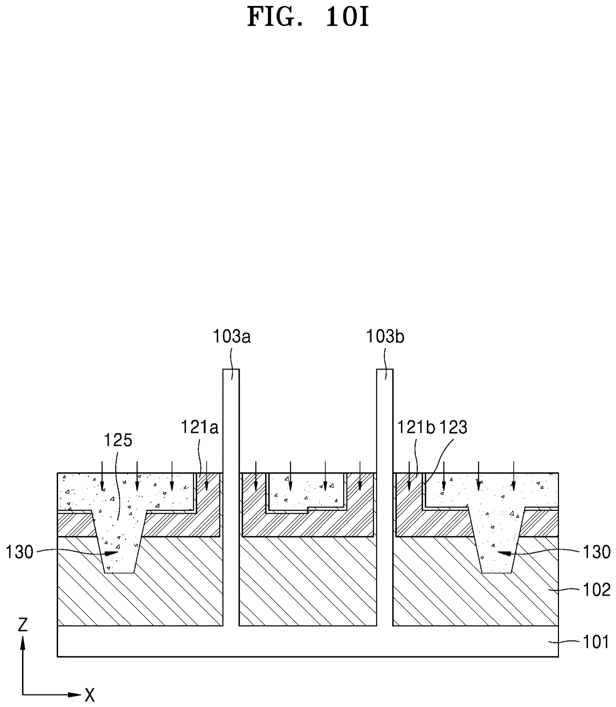

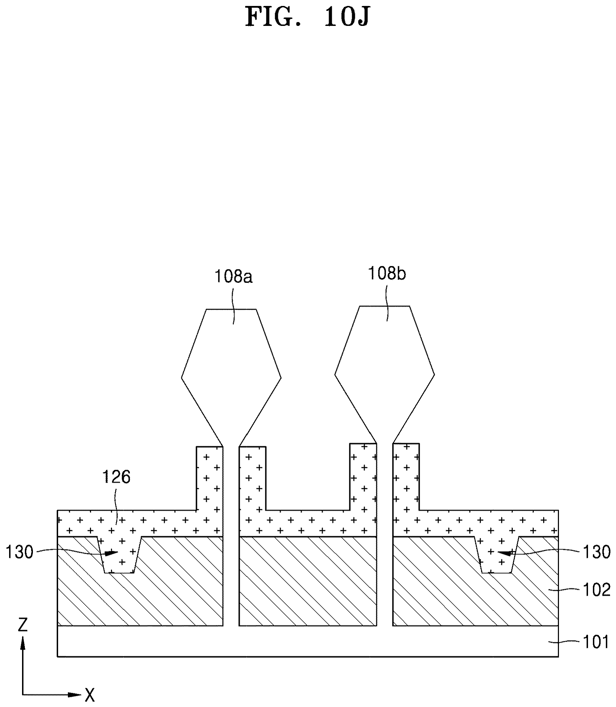

As described in more detail with respect to a method of manufacturing a semiconductor device described below, the gate cut GC may be formed before the formation of the gate insulating film 104 and the gate electrode 105. In a process of forming the gate cut GC, since a trench extending in the third direction may be formed by etching the isolation film 102 to a uniform depth in the third direction, the isolation film 102 may have a flat surface with almost no curvature around the gate cut GC in the third direction. In other words, a bottom surface of the gate cut GC may not be lower than a surface of the isolation film 102 around the gate cut GC in the third direction, and the bottom surface of the gate cut GC and the surface of the isolation film 102 around the gate cut GC may form a plane having almost the same height in the third direction. Alternatively, in processes illustrated in FIGS. 10I and 10J of forming the source region 107 and the drain region 108 in the method of manufacturing a semiconductor device described below, an area around the gate cut GC in the third direction may be further etched along the first direction. Then, as illustrated in FIG. 3, the gate cut GC may protrude further in the first direction than the surface of the isolation film 102 around the gate cut GC in the third direction.

Referring again to FIG. 1, the second portion of the gate electrode 105 may extend in the second direction along the upper surface of the isolation film 102 to a position of the gate cut GC. In other words, an end portion of the second portion of the gate electrode 105 may match the position of the gate cut GC. Accordingly, the gate electrode 105 of the field effect transistor TR may be electrically or signal-wise separated from the gate electrode 105 of another field effect transistor TR or another electronic device by the gate cut GC.

On the other hand, the gate insulating film 104, for example, the second portion of the gate insulating film 104, may extend toward the gate cut GC along a lower surface of the second portion of the gate electrode 105 and the upper surface of the isolation film 102. The gate insulating film 104 may extend continuously along a sidewall of the gate cut GC and an outer surface of the gate electrode 105 without being disconnected by the gate cut GC. Accordingly, the gate insulating film 104 may further include a third portion extending along a side surface of the second portion of the gate electrode 105 adjacent to the gate cut GC, an upper surface of the second portion of the gate electrode 105, and the outer sidewall surface of the first portion of the gate electrode 105 opposite to the active semiconductor layer 103. In other words, the gate insulating film 104 may include the first portion between the active semiconductor layer 103 and the first portion of the gate electrode 105, the second portion between the isolation film 102 and the second portion of the gate electrode 105, and the third portion extending along the outer surface of the gate electrode 105 through the sidewall of the gate cut GC. The first portion, the second portion, and the third portion of the gate insulating film 104 may extend continuously without disconnection.

In the cross-section shown in FIG. 1, the third portion of the gate insulating film 104 may be provided between the gate electrode 105 and the first passivation layer 106. For example, the third portion of the gate insulating film 104 may extend continuously along between the side surface of the end portion of the second portion of the gate electrode 105 and the first passivation layer 106, between the upper surface of the second portion of the gate electrode 105 and the first passivation layer 106, and between the first portion of the gate electrode 105 and the first passivation layer 106. A portion of the third portion of the gate insulating film 104 that is provided on the side surface of the end portion of the second portion of the gate electrode 105, may extend continuously without a step difference from the gate cut GC. Accordingly, the portion of the third portion of the gate insulating film 104 provided on the side surface of the end portion of the second portion of the gate electrode 105 may form the same plane as the gate cut GC.

Accordingly, the remaining surfaces except for the upper surface of the gate electrode 105 may be completely surrounded by the gate insulating film 104. Although not shown in FIG. 1, the gate insulating film 104 may also be provided on the surface of the gate electrode 105 viewed in the third direction. For example, referring to FIG. 2, the gate insulating film 104 may extend from between the active semiconductor layer 103 and the gate electrode 105 to the side surface of the gate electrode 105 in the third direction. In other words, the gate insulating film 104 may also be provided between the side surface of the gate electrode 105 and the first passivation layer 106 in the third direction or between the side surface of the gate electrode 105 and the second passivation layer 109 in the third direction.

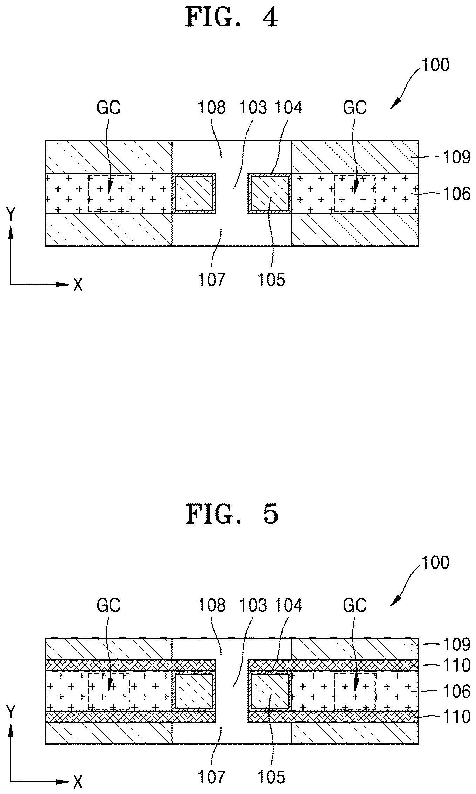

FIG. 4 illustrates a horizontal cross-sectional structure of the semiconductor device 100 taken along line A3-A3' of FIG. 1. In other words, FIG. 4 illustrates a cross-section of a portion of the active semiconductor layer 103 of the semiconductor device 100, taken by cutting the active semiconductor layer 103 into a plane parallel to the second direction and the third direction. Referring to FIG. 4, the active semiconductor layer 103 may be provided between the source region 107 and the drain region 108 in the third direction. The gate electrode 105 may be provided on both sides of the active semiconductor layer 103 in the second direction. The surfaces of the gate electrode 105 may be surrounded by the gate insulating film 104. For example, the gate insulating film 104 may be provided between the gate electrode 105 and the active semiconductor layer 103, between the gate electrode 105 and the source region 107, between the gate electrode 105 and the drain region 108, and between the gate electrode 105 and the first passivation layer 106. FIG. 4 shows that the width of the source region 107 and the drain region 108 in the second direction is greater than the width of the active semiconductor layer 103 in the second direction, and the source region 107 and the drain region 108 extend to the outer sidewall surface of the gate electrode 105 in the second direction, but this is not necessarily limited thereto. The width of the source region 107 and the drain region 108 in the second direction may be greater or less than that shown in FIG. 4.

The first passivation layer 106 may be provided in the same region as the active semiconductor layer 103 and the gate electrode 105 in the third direction and may extend in the second direction. The second passivation layer 109 may be provided in the same region as the source region 107 and the drain region 108 in the third direction and may extend in the second direction. The gate cut GC may be located below the first passivation layer 106 as indicated by a dashed line.

FIG. 5 schematically illustrates a structure of a semiconductor device according to another embodiment. In particular, FIG. 5 shows the structure of the semiconductor device according to another embodiment in the same cross-section as FIG. 4. Referring to FIG. 5, the semiconductor device 100 may further include a spacer 110 provided on both sides of the gate electrode 105 in the third direction. The spacer 110 may extend in the second direction. Accordingly, the spacer 110 may be provided between the gate electrode 105 and the source region 107, between the gate electrode 105 and the drain region 108, and between the first passivation layer 106 and the second passivation layer 109 in the third direction. The spacer 110 may play a role in limiting positions of the active semiconductor layer 103, the gate insulating film 104, and the gate electrode 105 in a method of manufacturing a semiconductor device described below. The source region 107 and the drain region 108 may be separated from the gate insulating film 104, and the gate electrode 105 by the spacer 110. The active semiconductor layer 103 may penetrate the spacer 110 in the third direction and be electrically connected to the source region 107 and the drain region 108. The spacer 110 may include, for example, silicon nitride (SiN), but is not limited thereto.

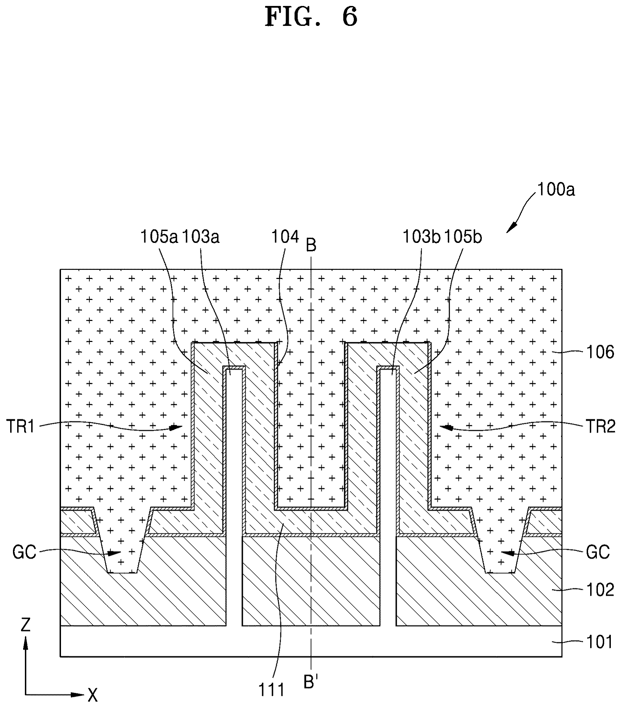

FIG. 6 schematically illustrates a structure of a semiconductor device according to another embodiment. The semiconductor device 100 described so far includes one field effect transistor TR between two adjacent gate cuts GC, but is not necessarily limited thereto. For example, two or more field effect transistors that share a gate signal may be provided between two adjacent gate cuts GC. Referring to FIG. 6, a semiconductor device 100a may include a first field effect transistor TR1 and a second field effect transistor TR2 provided between two adjacent gate cuts GC. FIG. 6 shows only one example, and in other embodiments, three or more field effect transistors may be provided between two adjacent gate cuts GC. The first field effect transistor TR1 and the second field effect transistor TR2 may be arranged adjacent to each other in the second direction. Depending on the purpose of the semiconductor device 100a, the first field effect transistor TR1 and the second field effect transistor TR2 may include different types of field effect transistors. For example, the first field effect transistor TR1 may include an n-channel metal oxide semiconductor (NMOS) transistor and the second field effect transistor TR2 may include a p-channel metal oxide semiconductor (PMOS) transistor.

The structure of each of the first field effect transistor TR1 and the second field effect transistor TR2 may be identical to the structure of the field effect transistor TR shown in FIG. 1. For example, the first field effect transistor TR1 may include a first active semiconductor layer 103a, a gate insulating film 104, and a first gate electrode 105a. Although not shown in FIG. 6, the first field effect transistor TR1 in the same cross-section as FIG. 2 may further include a first source region and a first drain region. The second field effect transistor TR2 may include a second active semiconductor layer 103b, a gate insulating film 104, and a second gate electrode 105b. Although not shown in FIG. 6, the second field effect transistor TR2 in the same cross-section as FIG. 2 may further include a second source region and a second drain region.

The first gate electrode 105a may be provided to surround three surfaces of the first active semiconductor layer 103a. The second gate electrode 105b may be provided to surround three surfaces of the second active semiconductor layer 103b. The gate insulating film 104 may be provided to surround three surfaces of the first active semiconductor layer 103a between the first active semiconductor layer 103a and the first gate electrode 105a, and to surround three surfaces of the second active semiconductor layer 103b between the second active semiconductor layer 103b and the second gate electrode 105b.

The first gate electrode 105a of the first field effect transistor TR1 and the second gate electrode 105b of the second field effect transistor TR2 may be formed integrally so that the first field effect transistor TR1 and the second field effect transistor TR2 may share the same gate signal. In other words, the first gate electrode 105a and the second gate electrode 105b may be considered as one gate electrode, and one gate electrode may be considered as extending between the first active semiconductor layer 103a of the first field effect transistor TR1 and the second active semiconductor layer 103b of the second field effect transistor TR2. Similarly, the gate insulating film 104 respectively surrounding surfaces of the first gate electrode 105a and the second gate electrode 105b may be formed integrally. In other words, it may be seen that one gate insulating film 104 extends from the first field effect transistor TR1 to the second field effect transistor TR2.

In other words, the semiconductor device 100a may further include a gate connection portion 111 provided between the first gate electrode 105a of the first field effect transistor TR1 and the second gate electrode 105b of the second field effect transistor TR2. The first gate electrode 105a of the first field effect transistor TR1 and the second gate electrode 105b of the second field effect transistor TR2 may be electrically connected to each other via the gate connection portion 111. The first gate electrode 105a of the first field effect transistor TR1, the second gate electrode 105b of the second field effect transistor TR2, and the gate connection portion 111 may be formed integrally from a single conductive material. The gate connection portion 111 may be provided over the upper surface of the isolation film 102 between the first field effect transistor TR1 and the second field effect transistor TR2, and may extend in the second direction.

The gate insulating film 104 may be provided to surround a surface of the gate connection portion 111. The gate insulating film 104 may extend along the surfaces of the first gate electrode 105a of the first field effect transistor TR1, the second gate electrode 105b of the second field effect transistor TR2, and the gate connection portion 111. For example, the gate insulating film 104 may be provided to surround all surfaces of the first gate electrode 105a of the first field effect transistor TR1, the second gate electrode 105b of the second field effect transistor TR2, and the gate connection portion 111, excluding an upper surface of the first gate electrode 105a of the first field effect transistor TR1 and an upper surface of the second gate electrode 105b of the second field effect transistor TR2.

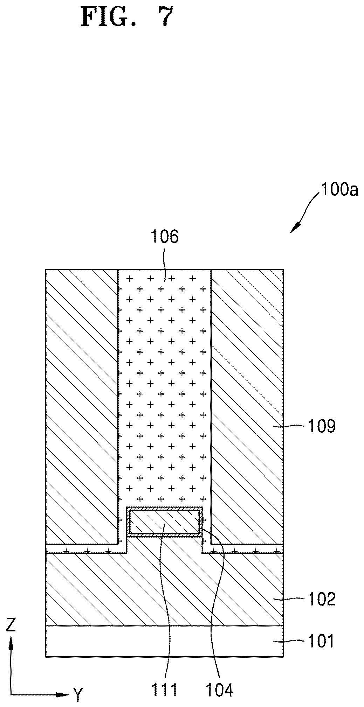

FIG. 7 illustrates a vertical cross-sectional structure of the semiconductor device 100a taken along line B-B' of FIG. 6. In other words, FIG. 7 illustrates a cross-section of the gate connection portion 111 of the semiconductor device 100a, by cutting the gate connection portion 111 into a plane parallel to the first direction and the third direction. Referring to FIG. 7, both side surfaces of the gate connection portion 111 in the third direction, a lower surface of the gate connection portion 111 and an upper surface of the gate connection portion 111 may be surrounded by the gate insulating film 104. The gate connection portion 111 and the gate insulating film 104 may be covered by the first passivation layer 106.

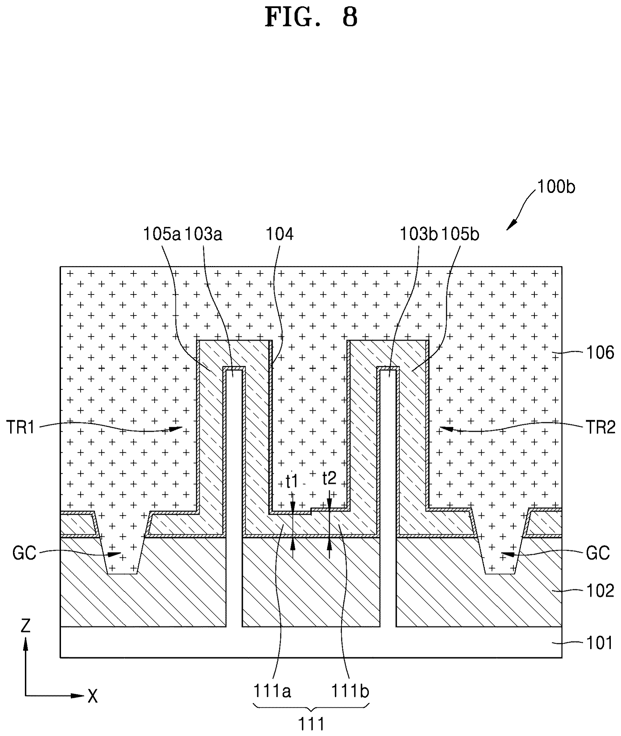

FIG. 8 schematically illustrates a structure of a semiconductor device according to another embodiment. A semiconductor device 100b may include a first field effect transistor TR1 and a second field effect transistor TR2 having different threshold voltages. Referring to FIG. 8, in order to individually and differently adjust the threshold voltage of the first field effect transistor TR1 and the threshold voltage of the second field effect transistor TR2, a thickness of the first gate electrode 105a of the first field effect transistor TR1 may be different from a thickness of the second gate electrode 105b of the second field effect transistor TR2. As described in more detail with respect to a method of manufacturing a semiconductor device described below, the first gate electrode 105a of the first field effect transistor TR1, the second gate electrode 105b of the second field effect transistor TR2, and the gate connection portion 111 may be formed conformally integrally. Accordingly, a step difference may exist between the first gate electrode 105a of the first field effect transistor TR1 and the second gate electrode 105b of the second field effect transistor TR2.

The gate connection portion 111 may include a first gate connection portion 111a closer to the first gate electrode 105a of the first field effect transistor TR1 and a second gate connection portion 111b closer to the second gate electrode 105b of the second field effect transistor TR2. A first direction thickness t1 of the first gate connection portion 111a may be equal to a second direction thickness of the first gate electrode 105a of the first field effect transistor TR1. A first direction thickness t2 of the second gate connection portion 111b may be equal to a second direction thickness of the second gate electrode 105b of the second field effect transistor TR2. When the second direction thickness of the first gate electrode 105a of the first field effect transistor TR1 is different from the second direction thickness of the second gate electrode 105b of the second field effect transistor TR2, the first direction thickness t1 of the first gate connection portion 111a may be different from the first direction thickness t2 of the second gate connection portion 111b. Accordingly, the step difference may be formed at a boundary where the first gate connection portion 111a contacts the second gate connection portion 111b.

On the other hand, the gate insulating film 104 may have a uniform thickness regardless of a thickness of the first gate electrode 105a and a thickness of the second gate electrode 105b. In other words, the thickness of the gate insulating film 104 in the first field effect transistor TR1, the thickness of the gate insulating film 104 in the second field effect transistor TR2, and the thickness of the gate insulating film 104 surrounding the gate connection portion 111 may be substantially the same.

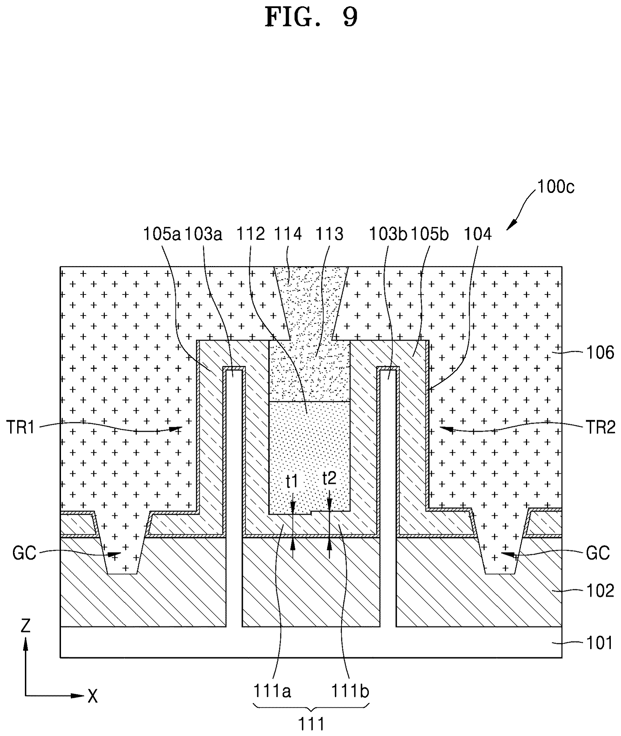

FIG. 9 schematically illustrates a structure of a semiconductor device according to another embodiment. Referring to FIG. 9, a semiconductor device 100c may further include a gate contact 114. The first field effect transistor TR1 and the second field effect transistor TR2 may receive a gate signal through the gate contact 114. For this purpose, the gate contact 114 may be provided to be electrically connected to the first gate electrode 105a of the first field effect transistor TR1 and/or the second gate electrode 105b of the second field effect transistor TR2. For example, the gate contact 114 may be electrically connected to the first gate electrode 105a of the first field effect transistor TR1 and/or the second gate electrode 105b of the second field effect transistor TR2, between the first gate electrode 105a of the first field effect transistor TR1 and the second gate electrode 105b of the second field effect transistor TR2. The gate insulating film 104 provided on the surface of the first gate electrode 105a of the first field effect transistor TR1 facing the second field effect transistor TR2, the surface of the second gate electrode 105b of the second field effect transistor TR2 facing the first field effect transistor TR1, and the upper surface of the gate connection portion 111, may be removed so that the first gate electrode 105a of the first field effect transistor TR1 and/or the second gate electrode 105b of the second field effect transistor TR2 may be electrically connected to the gate contact 114.

The semiconductor device 100c may further include an insulating filler 112 to reduce parasitic capacitance. The insulating filler 112 may include an insulating dielectric material. For example, the insulating filler 112 may include, but is not necessarily limited to, silicon oxide (SiO₂) having a relatively low dielectric constant. The insulating filler 112 may be filled to cover the upper surface of the gate connection portion 111 between the first gate electrode 105a of the first field effect transistor TR1 and the second gate electrode 105b of the second field effect transistor TR2. The semiconductor device 100c may also further include a conductive filler 113 filled on the insulating filler 112 between the first gate electrode 105a of the first field effect transistor TR1 and the second gate electrode 105b of the second field effect transistor TR2. The conductive filler 113 may include a conductive metal material. The gate contact 114 may be provided to penetrate the first passivation layer 106 and contact an upper surface of the conductive filler 113. According to an embodiment, the parasitic capacitance caused by the conductive filler 113 and the gate contact 114 may be reduced by reducing an area occupied by the conductive filler 113 and the gate contact 114 by using the insulating filler 112.

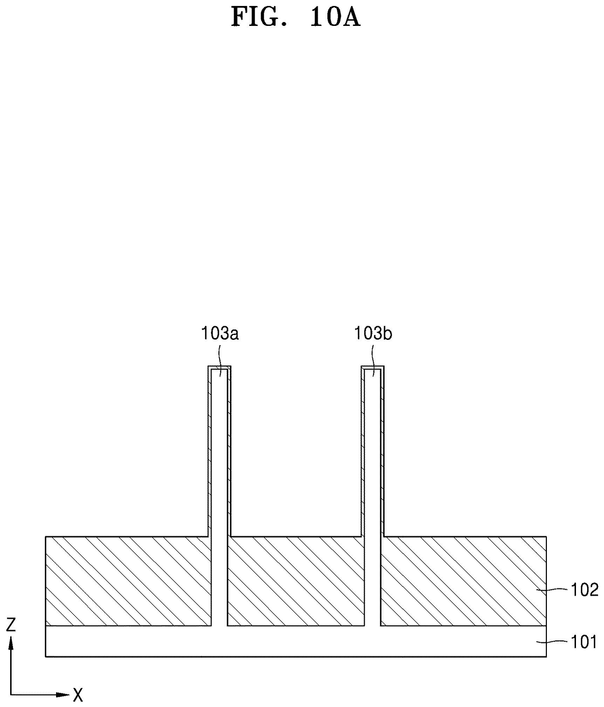

FIGS. 10A to 10S schematically illustrate a method of manufacturing a semiconductor device, according to an embodiment. For example, FIGS. 10A to 10S show a method of manufacturing the semiconductor devices 100b and 100c respectively illustrated in FIGS. 8 and 9, but the same principles as the method illustrated in FIGS. 10A to 10S may also be applied to a method of manufacturing the other semiconductor devices 100 and 100a.

First, referring to FIG. 10A, the first active semiconductor layer 103a and the second active semiconductor layer 103b that protrude and extend in the first direction from the substrate 101, may be formed. The first active semiconductor layer 103a and the second active semiconductor layer 103b may be provided adjacently in the second direction. The substrate 101 may include, for example, a silicon bulk substrate, and the first active semiconductor layer 103a and the second active semiconductor layer 103b may be formed by partially etching the silicon bulk substrate. In another example, the substrate 101 may include an SOI substrate, and the first active semiconductor layer 103a and the second active semiconductor layer 103b may be grown on the SOI substrate. The substrate 101 may include other types of semiconductor substrates, such as a group III-V compound semiconductor substrate such as GaAs and GaP, in addition to silicon.

The first active semiconductor layer 103a and the second active semiconductor layer 103b may include, for example, one semiconductor material among Si, Ge, and a compound semiconductor. The first active semiconductor layer 103a and the second active semiconductor layer 103b may be doped with the first conductivity type impurity. Although FIG. 10A illustrates that only two active semiconductor layers are formed on one substrate 101, the number of active semiconductor layers is not limited thereto, and a much larger number of active semiconductor layers may be formed on the substrate 101 at once. Hereinafter, for convenience, only a process of forming field effect transistors sharing one gate signal will be shown as an example.

Next, an insulating dielectric material may be deposited on the upper surface of the substrate 101 to form the isolation film 102. The material of the isolation film 102 may also be deposited on a surface of the first active semiconductor layer 103a and the surface of the second active semiconductor layer 103b. For example, a portion of the isolation film 102 may extend along both side surfaces of the first active semiconductor layer 103a in the second direction, both side surfaces of the second active semiconductor layer 103b in the second direction, an upper surface of the first active semiconductor layer 103a, and an upper surface of the second active semiconductor layer 103b. Therefore, the first active semiconductor layer 103a and the second active semiconductor layer 103b may be covered with the isolation film 102.

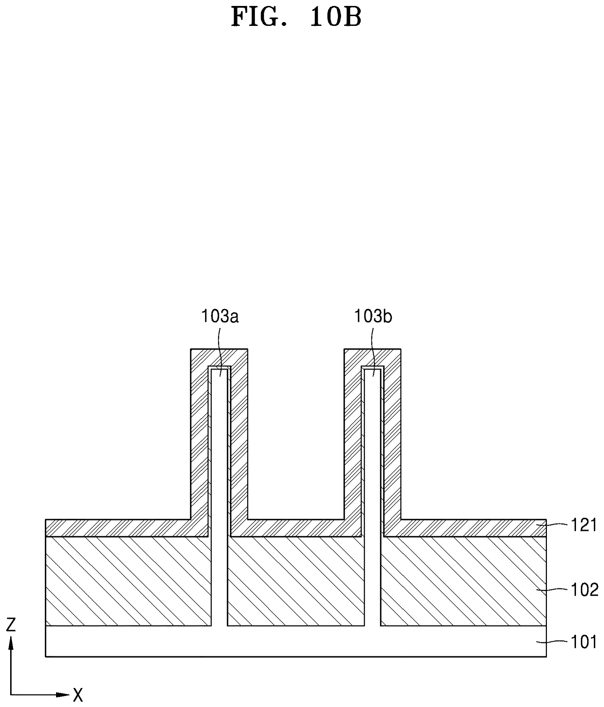

Referring to FIG. 10B, a dummy gate 121 may be conformally formed along the surface of the isolation film 102. The dummy gate 121 may include, for example, polycrystalline silicon germanium (poly-SiGe), but is not limited thereto. The dummy gate 121 may be formed with a constant thickness. For example, a first direction thickness of the dummy gate 121 in an area facing the upper surface of the substrate 101 may be approximately the same as a second direction thickness of the dummy gate 121 in an area facing a side surface of the first active semiconductor layer 103a and a side surface of the second active semiconductor layer 103b.

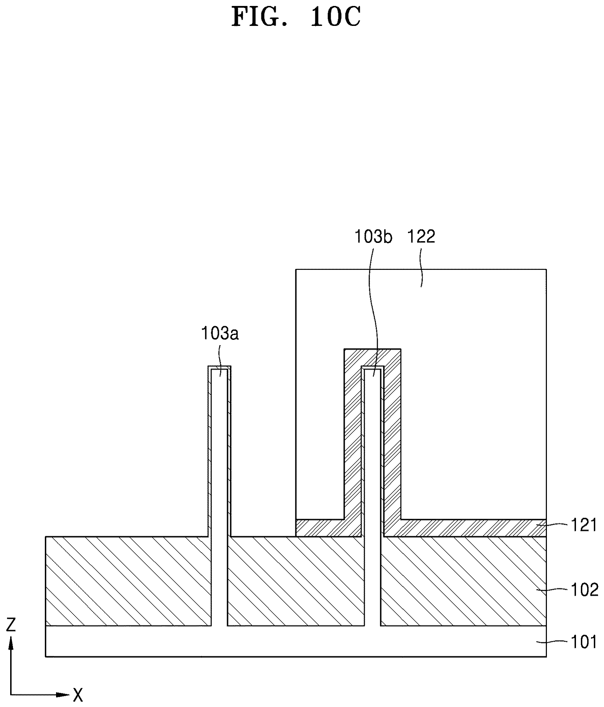

Referring to FIG. 10C, a mask 122 may be formed on the dummy gate 121 so as to completely cover the first active semiconductor layer 103a and the second active semiconductor layer 103b. For example, a height of the mask 122 may be greater than heights of the first active semiconductor layer 103a and the second active semiconductor layer 103b. Next, a portion of the mask 122 covering the first active semiconductor layer 103a may be removed to expose the dummy gate 121 around the first active semiconductor layer 103a. The mask 122 may remain only around the second active semiconductor layer 103b. Then, the dummy gate 121 exposed around the first active semiconductor layer 103a may be removed through an etching process. Accordingly, the isolation film 102 around the first active semiconductor layer 103a may be exposed. As a result, the dummy gate 121 may remain only around the second active semiconductor layer 103b.

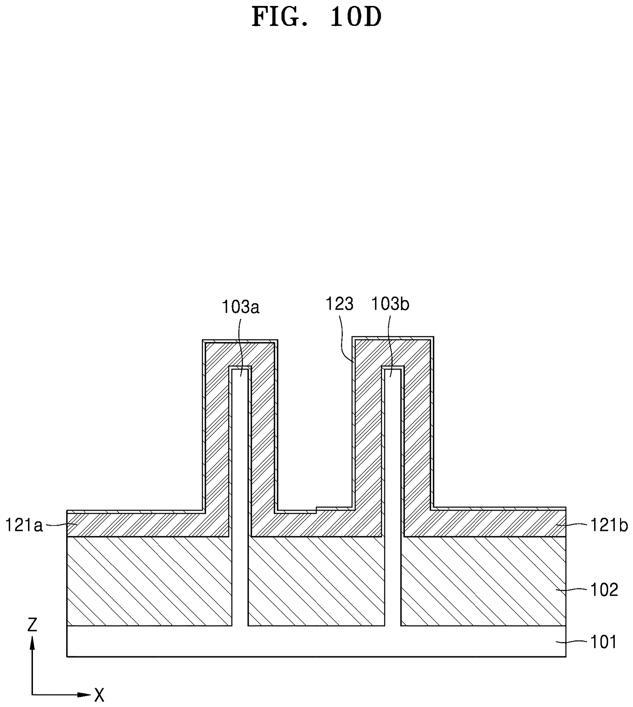

Referring to FIG. 10D, after the mask 122 is completely removed, a dummy gate material may be conformally further deposited thereon. Accordingly, the dummy gate material may be deposited around the first active semiconductor layer 103a to form a first dummy gate 121a. Additionally, the dummy gate material may be further added to the dummy gate 121 around the second active semiconductor layer 103b to form a second dummy gate 121b with increased thickness.

A thickness of the first dummy gate 121a may be uniform. For example, a first direction thickness of the first dummy gate 121a in an area facing the upper surface of the substrate 101 may be approximately the same as a second direction thickness of the first dummy gate 121a in an area facing a side surface of the first active semiconductor layer 103a. A thickness of the second dummy gate 121b may be uniform. For example, a first direction thickness of the second dummy gate 121b in an area facing the upper surface of the substrate 101 may be approximately the same as a second direction thickness of the second dummy gate 121b in an area facing a side surface of the second active semiconductor layer 103b. The thickness of the first dummy gate 121a may be different from the second dummy gate 121b. For example, the thickness of the first dummy gate 121a may be less than the thickness of the second dummy gate 121b. Therefore, a step difference may be formed at a boundary where the first dummy gate 121a contacts the second dummy gate 121b.

After the first dummy gate 121a and the second dummy gate 121b are formed, a dielectric layer 123 may be conformally formed to cover surfaces of the first dummy gate 121a and the second dummy gate 121b. The dielectric layer 123 may serve as an etching stop layer in a process described below. The dielectric layer 123 may include, for example, SiO₂ or SiN, but is not necessarily limited thereto.

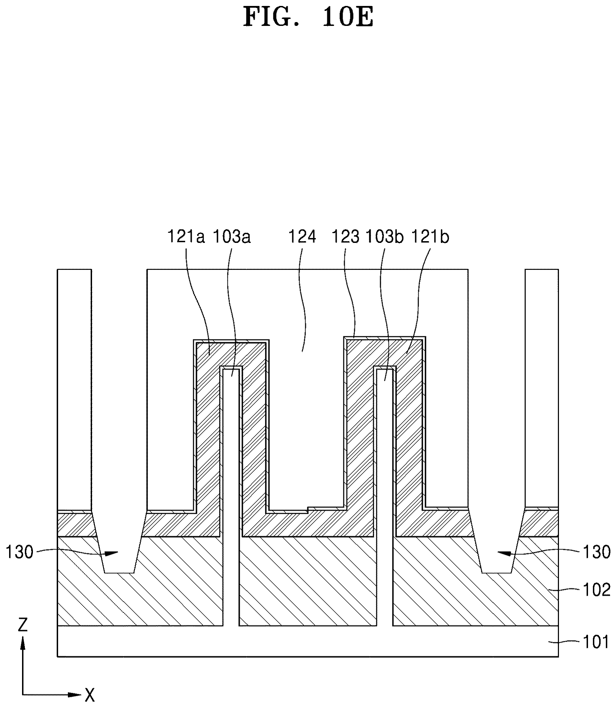

Referring to FIG. 10E, a mask 124 may be formed to completely cover the dielectric layer 123. For example, the mask 124 may be formed to a thickness that may completely cover the dielectric layer 123 on the first dummy gate 121a and the second dummy gate 121b. The mask 124 may be formed to have a flat upper surface. Next, the mask 124 may be patterned to expose the dielectric layer 123 in areas where the gate cut GC will be formed later. Next, the isolation film 102 may be partially etched to form concave trenches 130 that are adjacent to the first active semiconductor layer 103a and the second active semiconductor layer 103b, respectively, in the second direction and extend in the third direction. For example, the dielectric layer 123 within an exposed area of the patterned mask 124 may be removed by an etching process. The etching process may be performed so that the dielectric layer 123, the first dummy gate 121a, and the second dummy gate 121b within the exposed area are completely removed and the isolation film 102 is partially removed. Accordingly, the trench 130 having a concave shape may be formed in the isolation film 102.

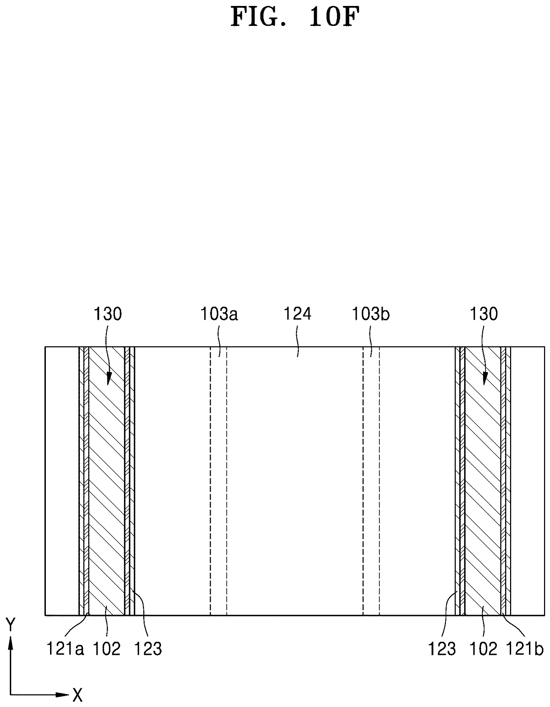

FIG. 10F is a plan view from above of the structure illustrated in FIG. 10E. Referring to FIG. 10F, the first active semiconductor layer 103a and the second active semiconductor layer 103b may extend in the third direction. Additionally, the trench 130 extending in the third direction, parallel to the first active semiconductor layer 103a and the second active semiconductor layer 103b, may be formed in the isolation film 102. For example, two trenches 130 may be formed adjacent to the first active semiconductor layer 103a and the second active semiconductor layer 103b, respectively, in the second direction so that the first active semiconductor layer 103a and the second active semiconductor layer 103b are positioned between two trenches 130 in the second direction.

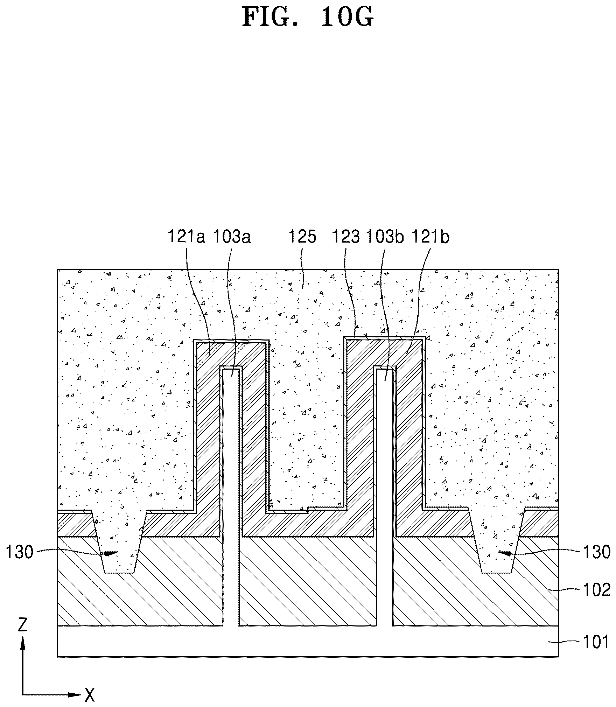

Referring to FIG. 10G, the mask 124 may be completely removed and a dummy block 125 may be formed. The dummy block 125 may be formed to fill the trenches 130 and completely cover the first active semiconductor layer 103a, the second active semiconductor layer 103b, and the dielectric layer 123. For example, the dummy block 125 may be formed to a thickness that may completely cover the dielectric layer 123 on the first dummy gate 121a and the second dummy gate 121b. The dummy block 125 may be formed to have a flat upper surface. The dummy block 125 may include, for example, polycrystalline silicon (poly-Si), but is not limited thereto.

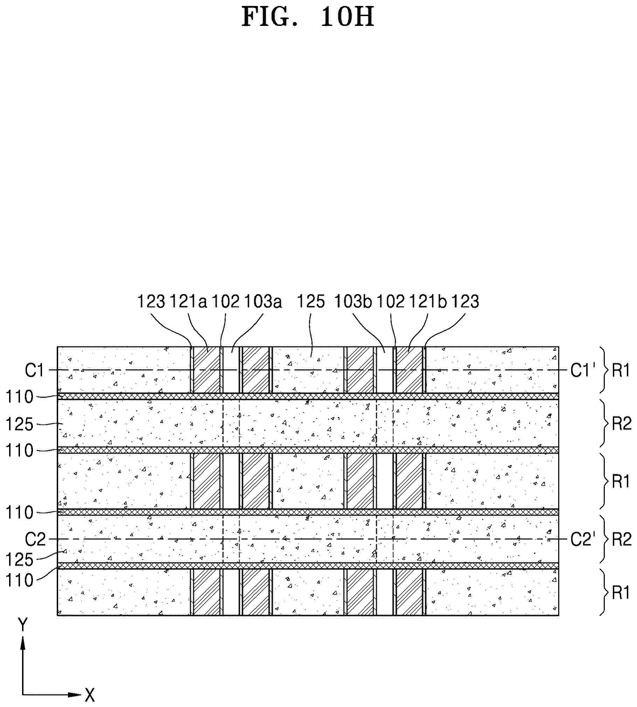

FIG. 10H is a plan view from above for explaining a process after FIG. 10G. Referring to FIG. 10H, a first region R1 in which the source region and the drain region are to be formed and a second region R2 in which the gate insulating film and the gate electrode are to be formed may be defined. For example, the first active semiconductor layer 103a and the second active semiconductor layer 103b may be exposed in the first region R1 through patterning. The dummy block 125 within the second region R2 may be left as is. Next, spacers 110 may be formed on both sides of the second region R2 in the third direction. A plurality of first regions R1 and a plurality of second regions R2 may be arranged alternately in the third direction. The first region R1, the second region R2, and the spacer 110 may extend in the second direction.

FIG. 10I shows a vertical cross-sectional structure taken along line C1-C1' of the first region R1 illustrated in FIG. 10H. Referring to FIG. 10I, the first active semiconductor layer 103a and the second active semiconductor layer 103b may be exposed to the outside within the first region R1 through an etching process. For example, a portion of the dielectric layer 123 around the first active semiconductor layer 103a and the second active semiconductor layer 103b, a portion of the first dummy gate 121a, a portion of the second dummy gate 121b, and a portion of the dummy block 125 may be removed.

Referring to FIG. 10J, the dielectric layer 123, the first dummy gate 121a, the second dummy gate 121b, and the dummy block 125 remaining within the first region R1 may be completely removed. Upper regions of the first active semiconductor layer 103a and the second active semiconductor layer 103b may also be partially removed. Additionally, an insulating layer 126 may be formed along side surfaces of the remaining first active semiconductor layer 103a and the remaining second active semiconductor layer 103b and along the upper surface of the isolation film 102. The insulating layer 126 may include the same material as the first passivation layer 106 or the second passivation layer 109 illustrated in FIGS. 1 and 2. Thereafter, a semiconductor doped with a second conductivity type impurity may be grown from upper portions of the remaining first active semiconductor layer 103a and the remaining second active semiconductor layer 103b to form first and second drain regions 108a and 108b. Although not shown in FIG. 10J, in the adjacent other first region R1, first and second source regions may be formed in the same manner as the first and second drain regions 108a and 108b. Although not illustrated, after forming the source region and the drain region, the second passivation layer 109 illustrated in FIG. 2 may be filled into the first region R1.

Thereafter, as described later, the gate insulating film and the gate electrode may be formed in the second region R2. Alternatively, a process of forming the gate insulating film and the gate electrode in the second region R2 may be performed first, and then the process of forming the source region and the drain region illustrated in FIGS. 10I and 10J may be performed.

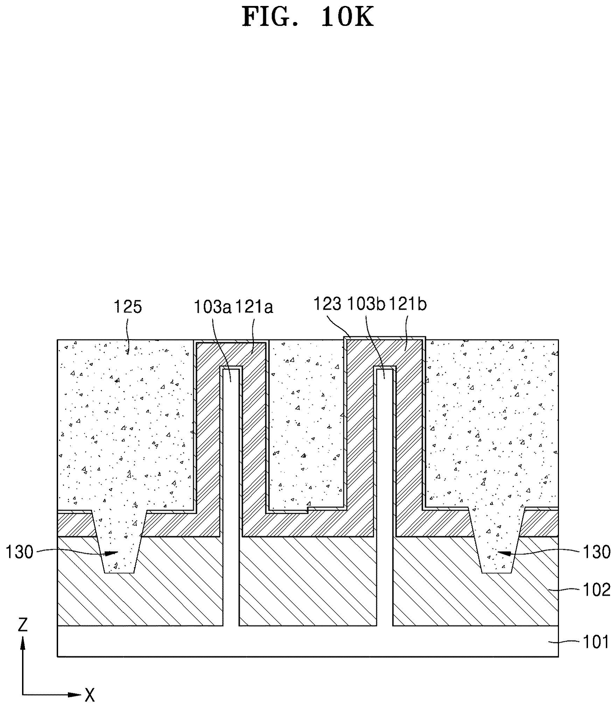

Referring to FIG. 10K, the dummy block 125 may be anisotropically etched so that the dielectric layer 123 is exposed in the second region R2. FIG. 10K shows a vertical cross-sectional structure taken along line C2-C2' of the second region R2 shown in FIG. 10H after exposing the dielectric layer 123. For example, an upper portion of the dummy block 125 may be removed using a dry etching method. The dielectric layer 123 may serve as an etching stop layer illustrated in FIG. 10K in an anisotropic etching process.

On the other hand, the trench 130 in the second region R2 may separate the gate insulating film and the gate electrode of the field effect transistor to be formed in a process described later, from the gate insulating film and the gate electrode of another field effect transistor that does not share a signal therebetween. In this respect, the trench 130 in the second region R2 may be called the gate cut GC.

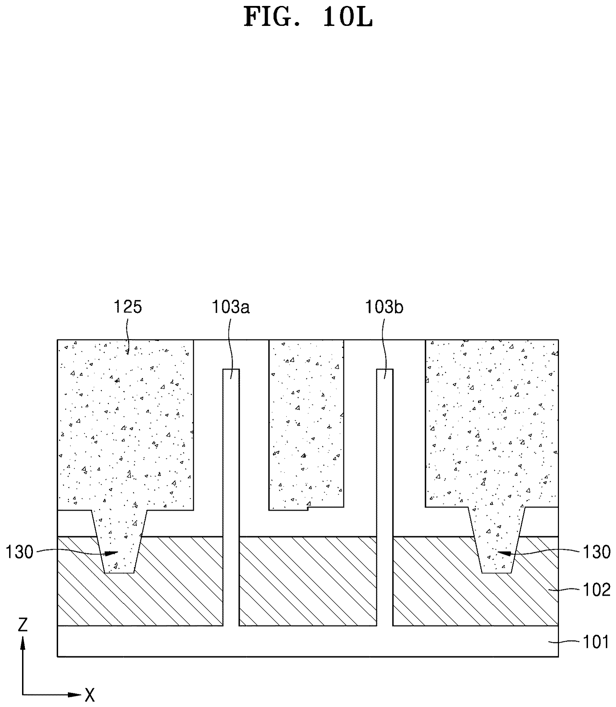

Referring to FIG. 10L, the dielectric layer 123, the first dummy gate 121a, and the second dummy gate 121b may be removed within the second region R2. Additionally, materials of the isolation film 102 on the side surfaces of the first active semiconductor layer 103a and the second active semiconductor layer 103b within the second region R2 may also be removed. For example, the first active semiconductor layer 103a and the second active semiconductor layer 103b may be exposed by isotropically removing materials inside the dummy block 125 using a wet etching method. Therefore, an empty space may be formed within the dummy block 125.

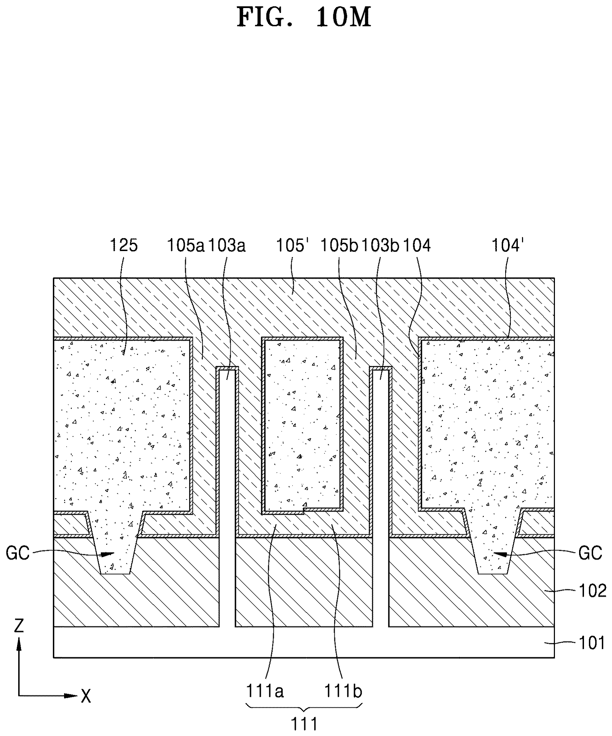

Referring to FIG. 10M, the gate insulating film 104, the first gate electrode 105a, the gate connection portion 111, and the second gate electrode 105b may be formed in the empty space within the dummy block 125. For example, the gate insulating film 104 may be first formed using an atomic layer deposition (ALD) method. Accordingly, the gate insulating film 104 may be conformally formed along the surfaces inside the dummy block 125. For example, the gate insulating film 104 may be conformally formed along a surface of the first active semiconductor layer 103a, a surface of the second active semiconductor layer 103b, an upper surface of the isolation film 102, and an inner surface of the dummy block 125 within the dummy block 125. The gate insulating film 104 may include a dielectric material having a relatively high dielectric constant. The gate insulating film 104 may include, for example, hafnium oxide (HfO₂), hafnium silicon oxide (HfSiO₄), lanthanum oxide (La₂O₃), lanthanum aluminum oxide (LaAlO₃), zirconium oxide (ZrO₂), zirconium silicon oxide (ZrSiO₄), tantalum oxide (Ta₂O₅), titanium oxide (TiO₂), aluminum oxide (Al₂O₃), etc.

Next, after the gate insulating film 104 is formed, the remaining empty space within the dummy block 125 may be conformally filled with a conductive material. For example, by conformally depositing the conductive material in the remaining empty space within the dummy block 125, which remains after the gate insulating film 104 is formed using the ALD method, the first gate electrode 105a, the gate connection portion 111, and the second gate electrode 105b may be simultaneously formed. In this respect, the first gate electrode 105a, the gate connection portion 111, and the second gate electrode 105b may be considered as a single layer formed integrally with the same material. The conductive material may include, for example, at least one of metal, metal nitride, metal carbide, and polycrystalline silicon. The metal may include, for example, aluminum (Al), tungsten (W), molybdenum (Mo), titanium (Ti), tantalum (Ta), and the like. The metal nitride may include, for example, titanium nitride (TiN), tantalum nitride (TaN), and the like. The metal carbide may include, for example, TiAlC, TaAlC, TiSiC, TaSiC, and the like.

The gate insulating film 104, the first gate electrode 105a, the gate connection portion 111, and the second gate electrode 105b formed in this manner may be separated by the gate cut GC, from the gate insulating film and the gate electrode of another field effect transistor that does not share a signal therebetween. The gate cut GC may define an end portion of the first gate electrode 105a and an end portion of the second gate electrode 105b within the second region R2.

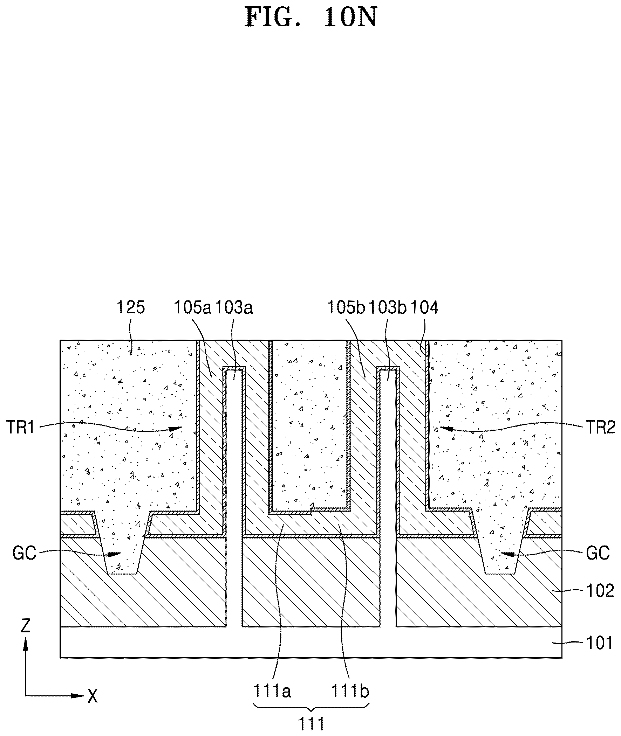

On the other hand, in a process of forming the gate insulating film 104, a gate insulating film material 104' may also be deposited on the upper surface of the dummy block 125. Additionally, in a process of forming the first gate electrode 105a, the gate connection portion 111, and the second gate electrode 105b, a gate electrode material 105' may also be deposited over the upper surface of the dummy block 125. Referring to FIG. 10N, the gate electrode material 105' and the gate insulating film material 104' remaining on the dummy block 125 may be removed by using an etching process or a chemical mechanical planarization (CMP) process. Through these processes, the first field effect transistor TR1 and the second field effect transistor TR2 may be formed.

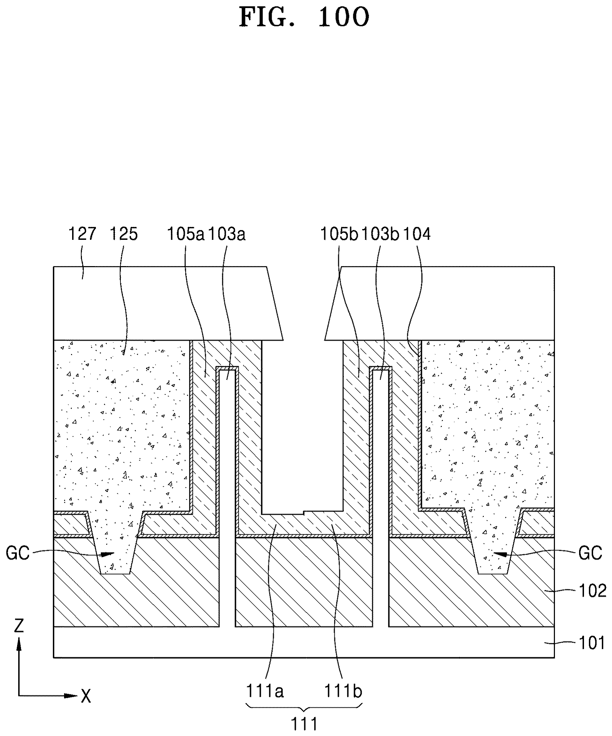

Referring to FIG. 10O, a mask 127 may be formed to cover all of the upper surface of the dummy block 125, the upper surface of the first gate electrode 105a, and the upper surface of the second gate electrode 105b. Then, after patterning the mask 127 so that the dummy block 125 between the first gate electrode 105a and the second gate electrode 105b is exposed, the dummy block 125 between the first gate electrode 105a and the second gate electrode 105b may be removed through an etching process. Additionally, the gate insulating film 104 between the first gate electrode 105a and the second gate electrode 105b may also be removed. Accordingly, an empty space may be formed between the first gate electrode 105a and the second gate electrode 105b.

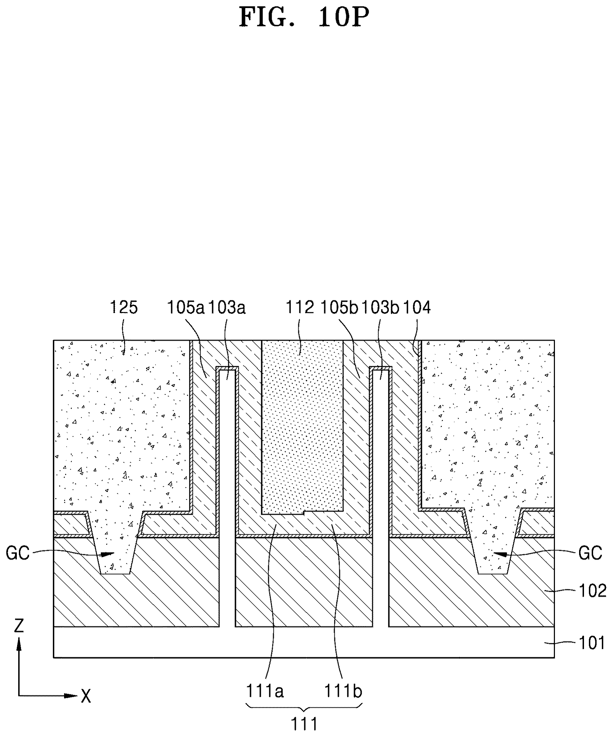

Referring to FIG. 10P, an insulating filler 112 may be filled in the empty space between the first gate electrode 105a and the second gate electrode 105b. For example, after depositing a material of the insulating filler 112 until the material covers the upper surface of the dummy block 125, the material of the insulating filler 112 over the dummy block 125 may be removed so that the dummy block 125 is exposed through a planarization process.

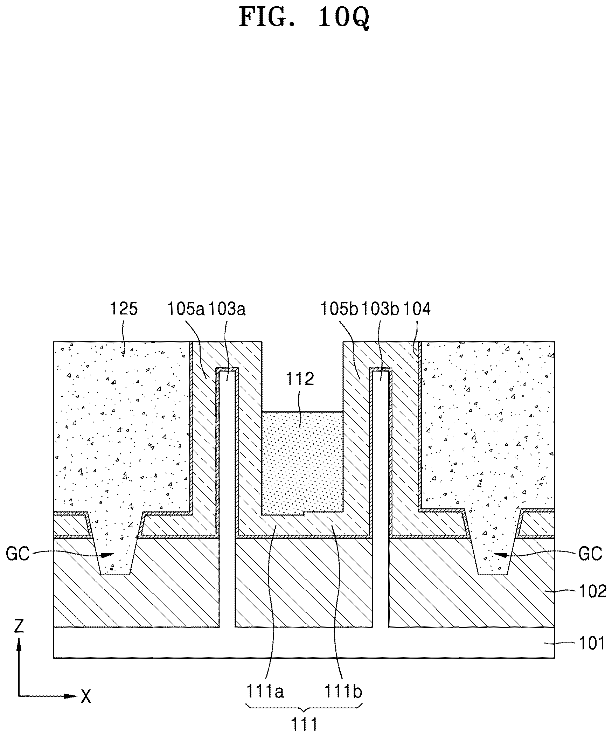

Referring to FIG. 10Q, a portion of the insulating filler 112 between the first gate electrode 105a and the second gate electrode 105b may be removed. Then, an empty space may be formed between the first gate electrode 105a and the second gate electrode 105b, and over the insulating filler 112.

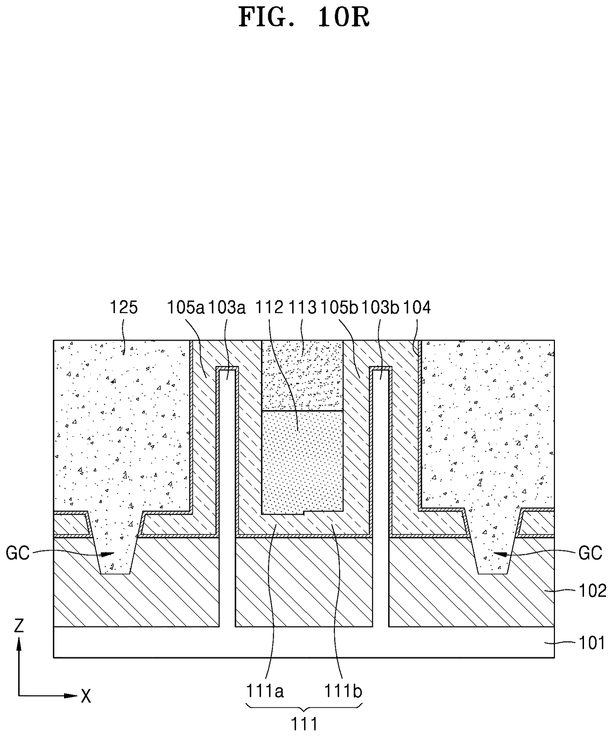

Referring to FIG. 10R, a conductive filler 113 may be filled in the empty space between the first gate electrode 105a and the second gate electrode 105b, and over the insulating filler 112. For example, after depositing a material of the conductive filler 113 until the material covers the upper surface of the dummy block 125, the material of the conductive filler 113 over the dummy block 125 may be removed so that the dummy block 125 is exposed through a planarization process.

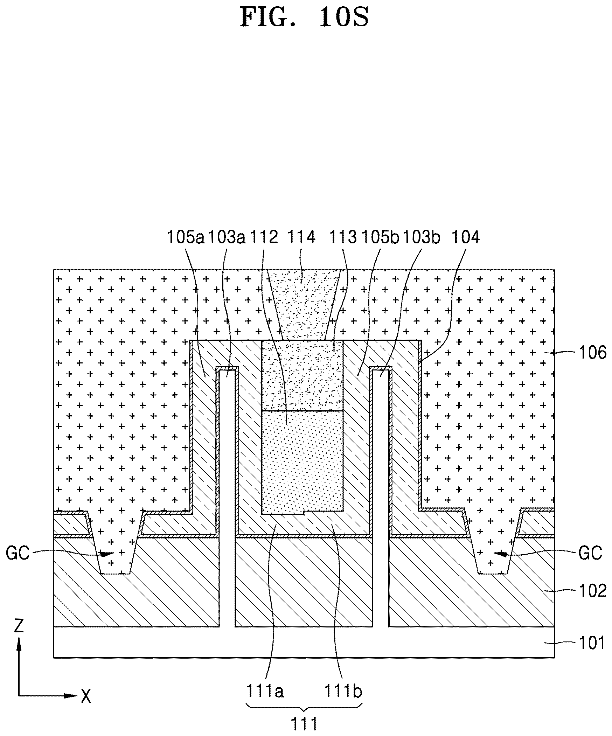

Referring to FIG. 10S, the remaining dummy block 125 may be completely removed and the first passivation layer 106 may be filled in the second region R2. Then, after forming a hole in the first passivation layer 106 so that the conductive filler 113 is exposed, the hole may be filled with a conductive material to form the gate contact 114.

Alternatively, when the gate contact 114 is not formed, the processes illustrated in FIGS. 10O to 10S may be omitted, and in the process illustrated in FIG. 10N, after the dummy block 125 is completely removed, the first passivation layer 106 may be filled in the second region R2. Additionally, as described above, the processes illustrated in FIGS. 10K to 10S may be performed prior to the processes illustrated in FIGS. 10I and 10J.

As described above, in the manufacturing process of the semiconductor device according to the embodiments, the gate cut GC may be formed prior to forming the gate electrode. Therefore, compared to a case where the gate electrode having a relatively high aspect ratio is first formed and then the gate cut is formed later, the level of difficulty of the manufacturing process may decrease and the possibility of defects occurring in the manufacturing process may also decrease, according to the embodiments.

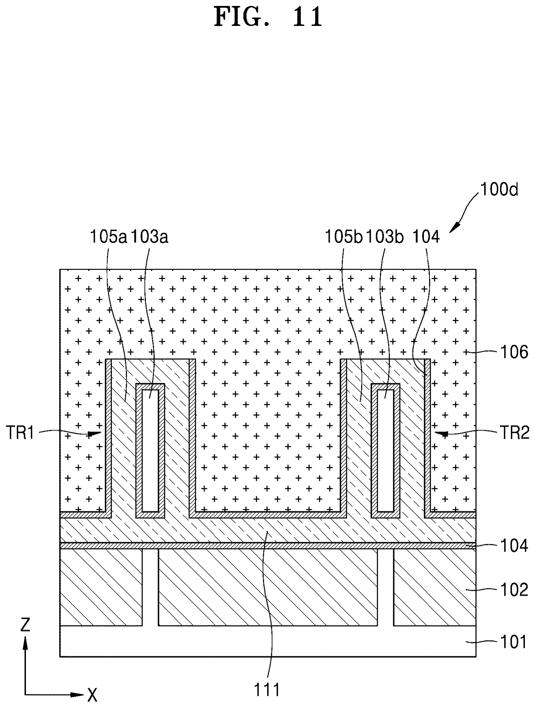

FIG. 11 schematically illustrates a structure of a semiconductor device according to another embodiment. So far, we have explained cases where the field effect transistor of the semiconductor device is a FinFET, but it is not limited thereto. The field effect transistor may also be a GAAFET. Referring to FIG. 11, a first active semiconductor layer 103a and a second active semiconductor layer 103b of a semiconductor device 100d may be physically separated from a substrate 101 and an isolation film 102 therebelow. In other words, the first active semiconductor layer 103a and the second active semiconductor layer 103b may be spaced apart from the substrate 101 and the isolation film 102 in the first direction and may extend in the first direction.

The gate insulating film 104 may surround four surfaces of the first active semiconductor layer 103a and four surfaces of the second active semiconductor layer 103b. In particular, a first portion of the gate insulating film 104 may completely surround all surfaces of the first active semiconductor layer 103a and the second active semiconductor layer 103b, that is, both side surfaces in the second direction, a lower surface, and an upper surface thereof. Between an end portion of the second portion of a first gate electrode 105a and an end portion of the second portion of a second gate electrode 105b or between two gate cuts, the second portion of the gate insulating film 104 may extend continuously in the second direction along an upper surface of the isolation film 102. For example, a second portion of the gate insulating film 104 may extend continuously in the second direction along the lower surface of the second portion of the first gate electrode 105a and the second portion of the second gate electrode 105b to the sidewall of the gate cut GC or the outer surface of the gate electrode 105, as illustrated in FIG. 1 and FIG. 6, etc. A first portion of the gate insulating film 104 surrounding the first active semiconductor layer 103a and the second active semiconductor layer 103b may be physically separated from a second portion of the gate insulating film 104 provided on an upper surface of the isolation film 102.

The first gate electrode 105a may surround four surfaces of the gate insulating film 104 surrounding the first active semiconductor layer 103a, particularly four surfaces of a first portion of the gate insulating film 104. The second gate electrode 105b may surround four surfaces of the gate insulating film 104 surrounding the second active semiconductor layer 103b, particularly four surfaces of the first portion of the gate insulating film 104. Additionally, the first gate electrode 105a, the gate connection portion 111, and the second gate electrode 105b may continuously extend in the second direction on the second portion of the gate insulating film 104.

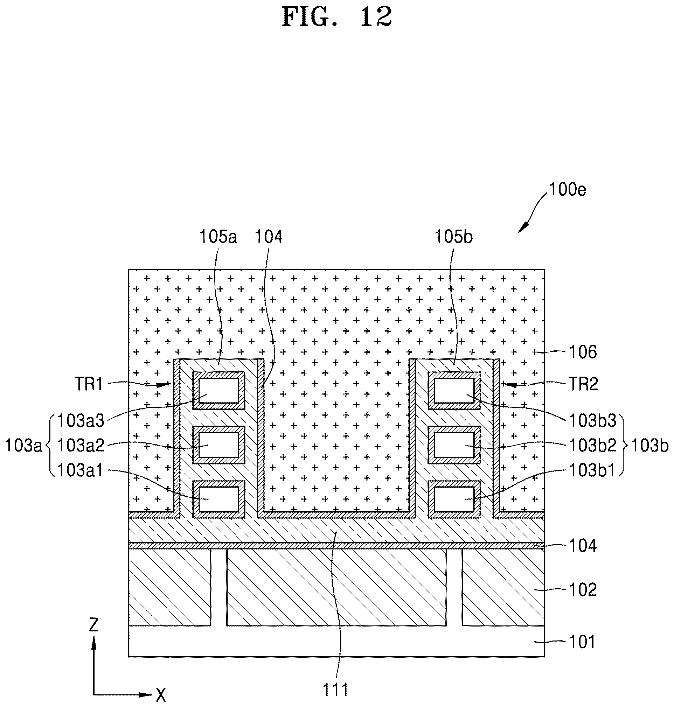

FIG. 12 schematically illustrates a structure of a semiconductor device according to another embodiment. Referring to FIG. 12, each of the first active semiconductor layer 103a and the second active semiconductor layer 103b of the semiconductor device 100e may include a plurality of channel elements spaced apart from each other in the first direction. For example, the first active semiconductor layer 103a may include a first channel element 103a1, a second channel element 103a2, and a third channel element 103a3 that are sequentially arranged while being spaced apart from each other in the first direction, and the second active semiconductor layer 103b may include a first channel element 103b1, a second channel elements 103b2, and a third channel element 103b3 that are sequentially arranged while being spaced apart from each other in the first direction. The first gate electrode 105a may surround each of the first channel element 103a1, the second channel element 103a2, and the third channel element 103a3 of the first active semiconductor layer 103a, and the second gate electrode 105b can surround each of the first channel element 103b1, the second channel element 103b2, and the third channel element 103b3 of the second active semiconductor layer 103b.

In addition, the first portion of the gate insulating film 104 may completely surround all surfaces (e.g., both side surfaces thereof in the second direction, lower surfaces thereof, and upper surfaces thereof) of the first channel element 103a1, the second channel element 103a2, and the third channel element 103a3 of the first active semiconductor layer 103a and the first channel element 103b1, the second channel element 103b2, and the third channel element 103b3 of the second active semiconductor layer 103b, respectively. In other words, the gate insulating film 104 may be between each of the first channel element 103a1, the second channel element 103a2, and the third channel element 103a3 of the first active semiconductor layer 103a and the first gate electrode 105a, and the gate insulating film 104 may be between each of the first channel element 103b1, the second channel element 103b2, and the third channel element 103b3 of the second active semiconductor layer 103b and the second gate electrode 105b. Although FIG. 12 illustrates that each of the first active semiconductor layer 103a and the second active semiconductor layer 103b includes three channel elements, this is merely an example, and the number of channel elements is not limited to the number illustrated in FIG. 12.

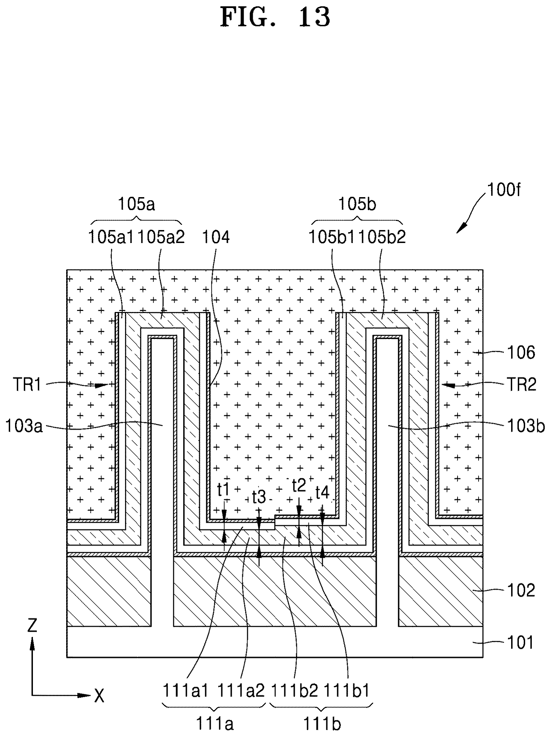

FIG. 13 schematically illustrates a structure of a semiconductor device according to another embodiment. Referring to FIG. 13, the first gate electrode 105a and the second gate electrode 105b of the semiconductor device 100f may respectively include a plurality of gate layers for controlling a threshold voltage of the field effect transistor. For example, the first gate electrode 105a may include a first gate layer 105a1 and a second gate layer 105a2. The second gate electrode 105b may include a first gate layer 105b1 and a second gate layer 105b2. Additionally, the first gate connection portion 111a may include a first connection layer 111a1 and a second connection layer 111a2, and the second gate connection portion 111b may include a first connection layer 111b1 and a second connection layer 111b2. The first gate layer 105a1 of the first gate electrode 105a, the first gate layer 105b1 of the second gate electrode 105b, the first connection layer 111a1 of the first gate connection portion 111a, and the first connection layer 111b1 of the second gate connection portion 111b may be formed integrally from a first conductive material. The second gate layer 105a2 of the first gate electrode 105a, the second gate layer 105b2 of the second gate electrode 105b, the second connection layer 111a2 of the first gate connection portion 111a, and the second connection layer 111b2 of the second gate connection portion 111b may be formed integrally from a second conductive material different from the first conductive material.

For example, in the process illustrated in FIG. 10M, after the gate insulating film 104 is conformally formed, the first conductive material may be conformally deposited to integrally form the first gate layer 105a1 of the first gate electrode 105a, the first gate layer 105b1 of the second gate electrode 105b, the first connection layer 111a1 of the first gate connection portion 111a, and the first connection layer 111b1 of the second gate connection portion 111b. Thereafter, the first gate layer 105a1 of the first gate electrode 105a, the first gate layer 105b1 of the second gate electrode 105b, the first connection layer 111a1 of the first gate connection portion 111a, and the first connection layer 111b1 of the second gate connection portion 111b may be formed, and a remaining space thereof may be filled with the second conductive material to integrally form the second gate layer 105a2 of the first gate electrode 105a, the second gate layer 105b2 of the second gate electrode 105b, the second connection layer 111a2 of the first gate connection portion 111a, and the second connection layer 111b2 of the second gate connection portion 111b.

Accordingly, the second gate layer 105a2 of the first gate electrode 105a may be surrounded by the first gate layer 105a1 of the first gate electrode 105a. The second gate layer 105b2 of the second gate electrode 105b may also be surrounded by the first gate layer 105b1 of the second gate electrode 105b. Additionally, the second connection layer 111a2 of the first gate connection portion 111a may be surrounded by the first connection layer 111a1 of the first gate connection portion 111a. The second connection layer 111b2 of the second gate connection portion 111b may be surrounded by the first connection layer 111b1 of the second gate connection portion 111b. Additionally, the first gate layer 105a1 of the first gate electrode 105a, the first gate layer 105b1 of the second gate electrode 105b, the first connection layer 111a1 of the first gate connection portion 111a, and the first connection layer 111b1 of the second gate connection portion 111b may be surrounded by the gate insulating film 104.

In this case, the first gate layer 105a1 of the first gate electrode 105a and the first connection layer 111a1 of the first gate connection portion 111a may have the same thickness t1. The first gate layer 105b1 of the second gate electrode 105b and the first connection layer 111b1 of the second gate connection portion 111b may have the same thickness t2. Additionally, the thickness t1 of the first gate layer 105a1 of the first gate electrode 105a and the first connection layer 111a1 of the first gate connection portion 111a may be the same as the thickness t2 of the first gate layer 105b1 of the second gate electrode 105b and the first connection layer 111b1 of the second gate connection portion 111b. In other words, the first gate layer 105a1 of the first gate electrode 105a, the first gate layer 105b1 of the second gate electrode 105b, the first connection layer 111a1 of the first gate connection portion 111a, and the first connection layer 111b1 of the second gate connection portion 111b may have the same thickness.

The second gate layer 105a2 of the first gate electrode 105a and the second connection layer 111a2 of the first gate connection portion 111a may have the same thickness t3. The second gate layer 105b2 of the second gate electrode 105b and the second connection layer 111b2 of the second gate connection portion 111b may have the same thickness t4. On the other hand, the thickness t3 of the second gate layer 105a2 of the first gate electrode 105a and the second connection layer 111a2 of the first gate connection portion 111a may be different from the thickness t4 of the second gate layer 105b2 of the second gate electrode 105b and the second connection layer 111b2 of the second gate connection portion 111b.

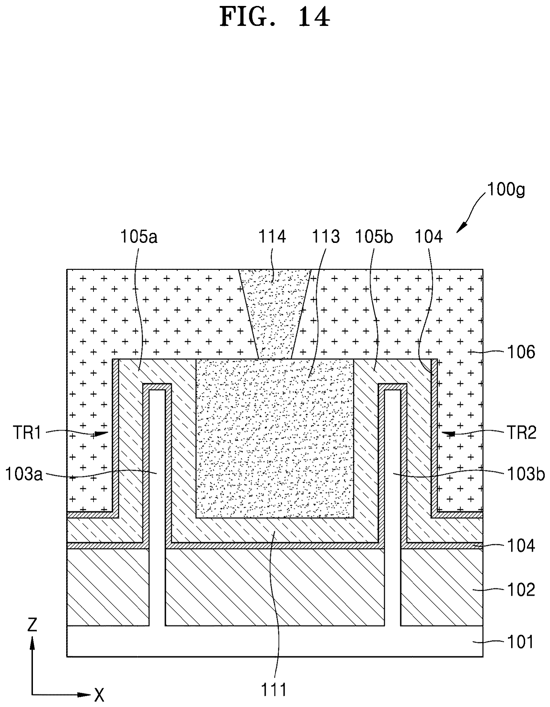

FIG. 14 schematically illustrates a structure of a semiconductor device according to another embodiment. Referring to FIG. 14, the semiconductor device 100g may not include the insulating filler 112, unlike the semiconductor device 100c illustrated in FIG. 9. In other words, the semiconductor device 100g may further include the conductive filler 113 provided to fill a space surrounded by the first gate electrode 105a, the second gate electrode 105b, and the gate connection portion 111.

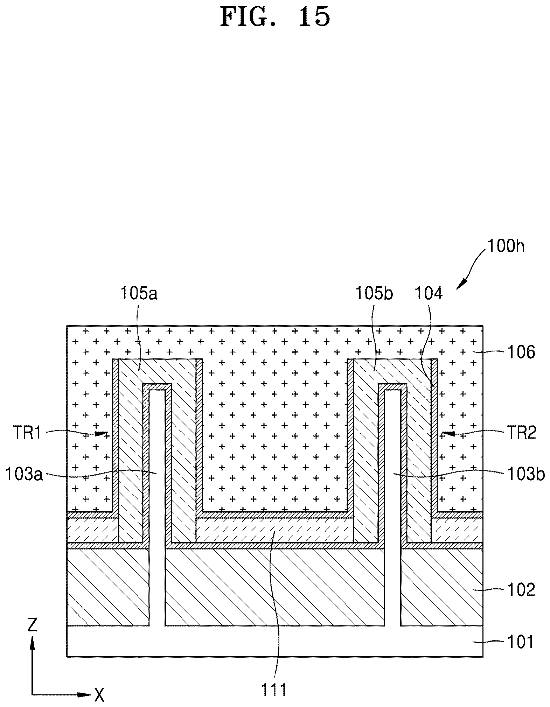

FIG. 15 schematically illustrates a structure of a semiconductor device according to another embodiment. So far, it has been described that the first gate electrode 105a, the second gate electrode 105b, and the gate connection portion 111 may be formed integrally from the same conductive material. The threshold voltage of the first field effect transistor TR1 may be affected by the material of the first gate electrode 105a, and the threshold voltage of the second field effect transistor TR2 may be affected by the material of the second gate electrode 105b. However, the material of the gate connection portion 111 may have little effect on the threshold voltage of the first and second field effect transistors TR1 and TR2. Taking this into consideration, the semiconductor device 100h may include the gate connection portion 111 including a conductive material different from the material of the first gate electrode 105a and the second gate electrode 105b. For example, the gate connection portion 111 may include the conductive material having higher electrical conductivity than the materials of the first gate electrode 105a and the second gate electrode 105b.

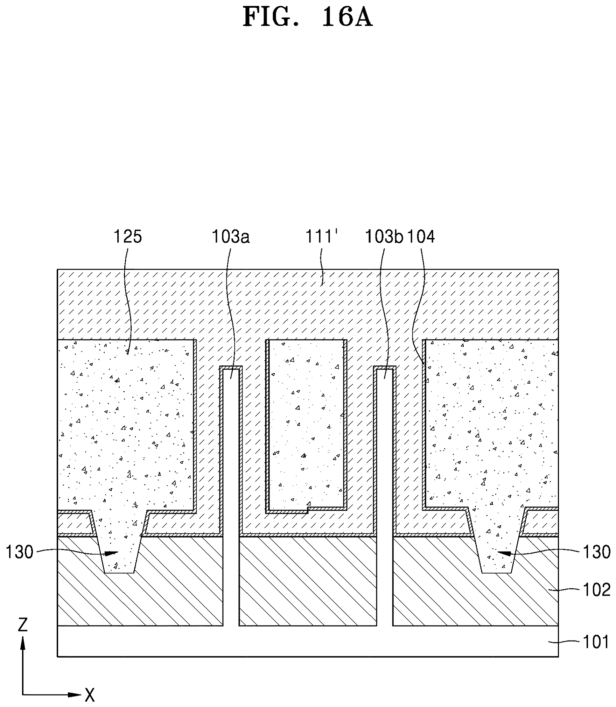

FIGS. 16A to 16C schematically illustrate a method of forming a gate connection portion 111 including the conductive material different from the materials of the first gate electrode 105a and the second gate electrode 105b. Referring to FIG. 16A, after the process illustrated in FIG. 10L, the gate insulating film 104 may be conformally formed along surfaces inside the dummy block 125. Next, a conductive material 111' may be deposited to completely fill an internal space of the dummy block 125. At this time, the conductive material 111' may also be deposited on the upper surface of the dummy block 125.

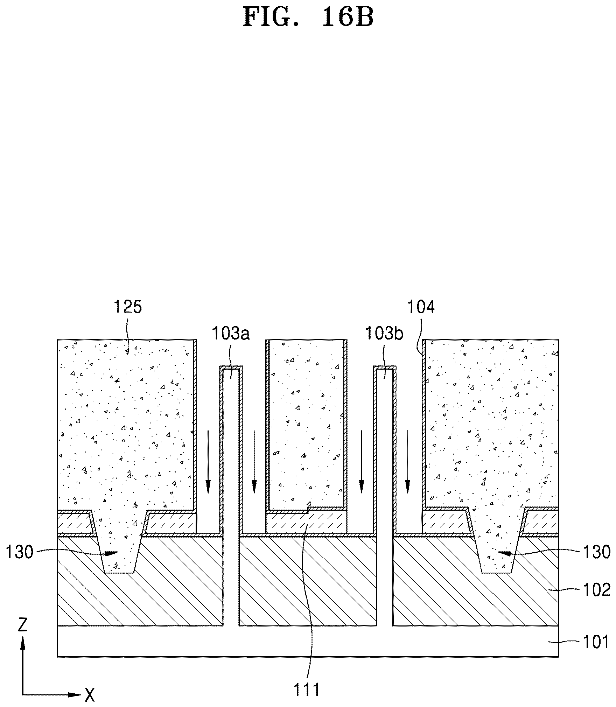

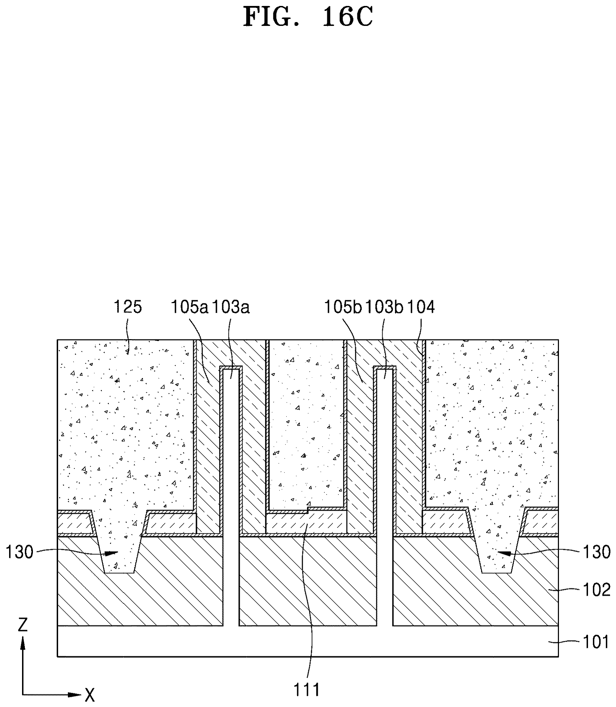

Referring to FIG. 16B, the gate connection portion 111 may be formed by removing the conductive material 111' exposed between the dummy blocks 125 through an etching process, leaving the conductive material 111' under the dummy block 125. Referring to FIG. 16C, the conductive material 111' may be removed and the remaining space may be filled with a gate electrode material to form first and second gate electrodes 105a and 105b. Next, the processes illustrated in FIGS. 10O to 10S may be performed, or the dummy block 125 may be removed and the first passivation layer 106 may be formed.

The semiconductor devices described above may be used in, for example, driver integrated circuits for displays, complementary metal oxide semiconductor (CMOS) inverters, CMOS static random access memory (SRAM) devices, CMOS NAND circuits, neural network devices, and/or various other electronic apparatuses.

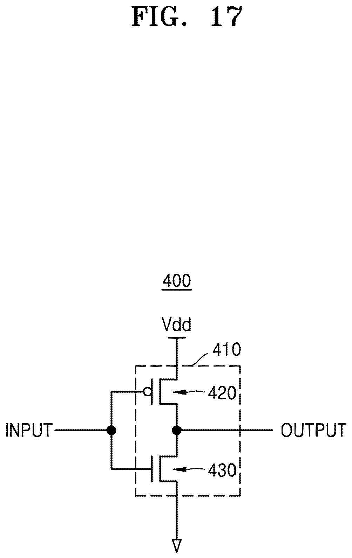

FIG. 17 is a circuit diagram of a CMOS inverter 400 according to an embodiment. Referring to FIG. 17, the CMOS inverter 400 may include a CMOS transistor 410. The CMOS transistor 410 may include a PMOS transistor 420 and an NMOS transistor 430 connected between a power terminal Vdd and a ground terminal. The CMOS transistor 410 may include the semiconductor device according to any one of the embodiments described above.

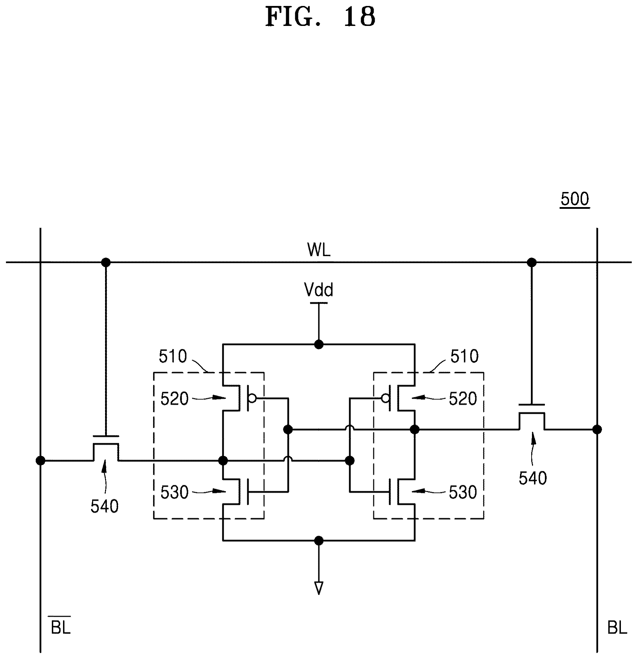

FIG. 18 is a circuit diagram of a CMOS SRAM device 500 according to an embodiment. Referring to FIG. 18, the CMOS SRAM device 500 may include a pair of driving transistors 510. Each of the pair of driving transistors 510 may include a PMOS transistor 520 and an NMOS transistor 530 connected between a power terminal Vdd and a ground terminal. The CMOS SRAM device 500 may further include a pair of transfer transistors 540. A source of the transfer transistor 540 may be cross-connected to a common node of the PMOS transistor 520 and the NMOS transistor 530 that constitute the driving transistor 510. A source of the PMOS transistor 520 may be connected to the power terminal Vdd, and a source of the NMOS transistor 530 may be connected to the ground terminal. A word line WL may be connected to gates of the pair of transfer transistors 540, and a bit line BL and an inverted bit line may be connected to drains of the pair of transfer transistors 540, respectively. At least one of the driving transistor 510 and the transfer transistor 540 of the CMOS SRAM device 500 may include the semiconductor device according to any one of the embodiments described above.

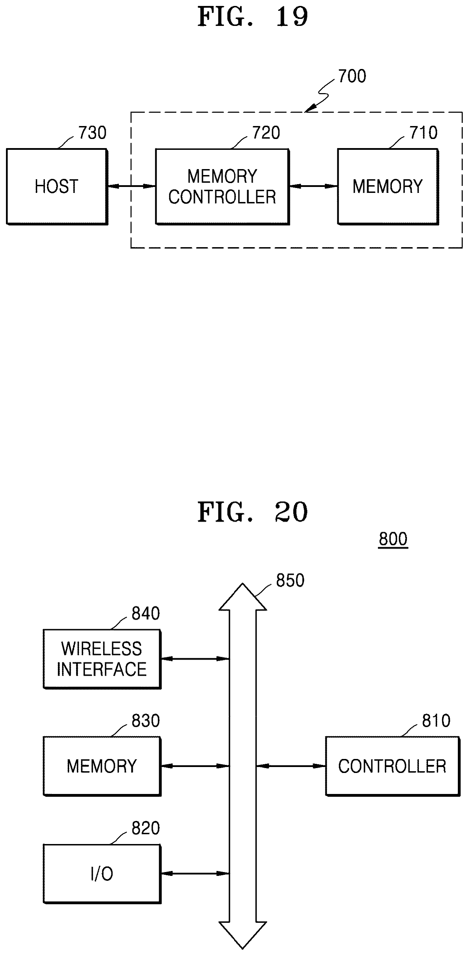

FIG. 19 is a block diagram illustrating an electronic apparatus 700 according to an embodiment. Referring to FIG. 19, the electronic apparatus 700 may include a memory 710 and a memory controller 720. The memory controller 720 may control the memory 710 to read data from and/or write data to the memory 710 in response to a request from a host 730. At least one of the memory 710 and the memory controller 720 may include the semiconductor device according to any one of the embodiments described above with reference to FIGS. 1 to 11.

FIG. 20 is a block diagram of an electronic apparatus 800 according to an embodiment. Referring to FIG. 20, the electronic apparatus 800 may constitute a wired/wireless communication device, or a device that may transmit and/or receive information in a wired or wireless environment. The electronic apparatus 800 may include a controller 810, an input/output (I/O) device 820, a memory 830, and a wireless interface 840, which are each interconnected via a bus 850.

The controller 810 may include at least one of a microprocessor, a digital signal processor, or a similar processing device. The I/O device 820 may include at least one of a keypad, a keyboard, or a display. The memory 830 may be used to store commands executed by the controller 810. For example, the memory 830 may be used to store user data. The electronic apparatus 800 may use the wireless interface 840 to transmit/receive data via a wireless communication network. The wireless interface 840 may include an antenna and/or a wireless transceiver. In some embodiments, the electronic apparatus 800 may be used for communication interface protocols of third generation communication systems, such as code division multiple access (CDMA), global system for mobile communications (GSM), north American digital cellular (NADC), extended-time division multiple access (E-TDMA), and/or wide band code division multiple access (WCDMA). At least one of the controller 810, the I/O device 820, the memory 830, and the wireless interface 840 of the electronic apparatus 800 may include the semiconductor device according to any one of the embodiments described above.

The embodiments explained so far may be summarized as follows.
(1) A semiconductor device according to an embodiment may include an active semiconductor layer, a gate insulating film provided to surround at least three surfaces of the active semiconductor layer, a gate electrode extended in a first direction to surround at least three surfaces of the gate insulating film, and a gate cut having a shape of a trench to electrically isolate the gate electrode from another gate electrode or another electronic device and provided to face the gate electrode in a second direction perpendicular to the first direction, wherein the gate insulating film may extend along a lower surface of the gate electrode to a sidewall of the gate cut.
(2) The semiconductor device may further include an isolation film including an insulating dielectric material, and the active semiconductor layer may extend to protrude over the isolation film in the first direction.
(3) The gate electrode may include a first portion extending along a surface of the active semiconductor layer from an upper surface of the isolation film to surround the active semiconductor layer, and a second portion extending in the second direction on the upper surface of the isolation film.
(4) The gate insulating film may include a first portion provided between the active semiconductor layer and the first portion of the gate electrode, and a second portion provided between the upper surface of the isolation film and the second portion of the gate electrode.
(5) The gate insulating film may further include a third portion extending to an outer surface of the gate electrode opposite to the active semiconductor layer through a side wall of the gate cut, and the first portion, the second portion, and the third portion of the gate insulating film may extend continuously.
(6) The end portion of the second part of the gate electrode may match a position of the gate cut.
(7) The gate cut may have the shape of the trench provided in an upper surface of the isolation film, and a bottom surface of the gate cut may further protrude in the first direction than the upper surface of the isolation film adjacent to the gate cut in a third direction perpendicular to the first and second directions.
(8) The active semiconductor layer may include a first active semiconductor layer and a second active semiconductor layer adjacent in the second direction, the gate electrode may include a first gate electrode surrounding at least three surfaces of the first active semiconductor layer and a second gate electrode surrounding at least three surfaces of the second active semiconductor layer, and the semiconductor device may further include a gate connection portion provided between the first gate electrode and the second gate electrode.
(9) In an embodiment, the first gate electrode, the second gate electrode, and the gate connection portion may be formed integrally from a single conductive material.
(10) In another embodiment, the gate connection portion may include a conductive material having a greater electrical conductivity than materials of the first gate electrode and the second gate electrode.
(11) The gate insulating film may be provided to surround at least three surfaces of the first active semiconductor layer between the first active semiconductor layer and the first gate electrode, and to surround at least three surfaces of the second active semiconductor layer between the second active semiconductor layer and the second gate electrode.
(12) The gate insulating film may extend along surfaces of the first gate electrode, the gate connecting portion, and the second gate electrode.
(13) The gate insulating film may surround a lower surface of the gate connection portion, an upper surface of the gate connection portion, and both side surfaces of the gate connection portion in a third direction perpendicular to the first and second directions.
(14) The gate connection portion may include a first gate connection portion adjacent to the first gate electrode and a second gate connection portion adjacent to the second gate electrode, and a first direction thickness of the first gate connection portion may be different from a first direction thickness of the second gate connection portion.
(15) Each of the first gate electrode and the second gate electrode may include a first gate layer and a second gate layer surrounded by the first gate layer, and each of the first gate connection portion and the second gate connection portion may include a first connection layer and a second connection layer surrounded by the first connection layer.
(16) The first gate layer of the first gate electrode, the first gate layer of the second gate electrode, the first connection layer of the first gate connection portion, and the first connection layer of the second gate connection portion may include a first conductive material.
(17) The second gate layer of the first gate electrode, the second gate layer of the second gate electrode, the second connection layer of the first gate connection portion, and the second connection layer of the second gate connection portion may include a second conductive material different from the first conductive material.
(18) The first connection layer of the first gate connection portion and the first connection layer of the second gate connection portion may have the same thickness, and the first direction thickness of the second connection layer of the first gate connection portion may be different from the first direction thickness of the second connection layer of the second gate connection portion.
(19) In an embodiment, the semiconductor device may further include an insulating filler provided to cover the gate connection between the first gate electrode and the second gate electrode, a conductive filler provided on the insulating filler between the first gate electrode and the second gate electrode, and a gate contact contacting an upper surface of the conductive filler.
(20) In another embodiment, the semiconductor device may further include a conductive filler provided to cover the gate connection portion between the first gate electrode and the second gate electrode, and a gate contact contacting an upper surface of the conductive filler.
(21) The gate insulating film may include a first portion surrounding four surfaces of the active semiconductor layer and a second portion extending in a second direction along a lower surface of the gate electrode to the sidewall of the gate cut, the first portion of the gate insulating film and the second portion of the gate insulating film being separated, and the gate electrode may surround four surfaces of the first portion of the gate insulating film.
(22) The active semiconductor layer may include a plurality of channel elements spaced apart from each other in the first direction, and the first portion of the gate insulating film may surround surfaces of each of the plurality of channel elements.
(23) A method of manufacturing a semiconductor device, the method may include: forming an active semiconductor layer that protrudes and extends in a first direction from a substrate, forming an isolation film covering an upper surface of the substrate and a side surface of the active semiconductor layer, conformally forming a dummy gate along a surface of the isolation film, by partially etching the isolation film, forming a trench adjacent to the active semiconductor layer in a second direction perpendicular to the first direction and extending in a third direction perpendicular to the first and second directions, forming a dummy block to cover the trench and the active semiconductor layer, removing the isolation film on side surfaces of the dummy gate and the active semiconductor layer to expose the active semiconductor layer and form an empty space within the dummy block, conformally forming a gate insulating film along an inner surface of the dummy block and the surface of the active semiconductor layer, forming a gate electrode, by filling the empty space within the dummy block remaining after the gate insulating film is formed, with a conductive material; and removing the dummy block.
(24) An electronic apparatus may include a memory, and a memory controller controlling the memory to read data from the memory and/or write data to the memory, wherein at least one of the memory and the memory controller comprises a semiconductor device, the semiconductor device may include an active semiconductor layer, a gate insulating film provided to surround at least three surfaces of the active semiconductor layer, a gate electrode extending in a first direction to surround at least three surfaces of the gate insulating film, and a gate cut having a shape of a trench to electrically isolate the gate electrode from another gate electrode or another electronic device, and provided to face the gate electrode in a second direction perpendicular to the first direction, wherein the gate insulating film extends to a sidewall of the gate cut along a lower surface of the gate electrode.

According to the embodiments disclosed herein, the gate cut may be first formed prior to forming the gate electrode in the manufacturing process of the semiconductor device. Therefore, compared to a case where the gate electrode having a relatively high aspect ratio is first formed and then the gate cut is formed later, the level of difficulty of the manufacturing process may decrease and the possibility of defects occurring in the manufacturing process may also decrease, according to the embodiments.

Although the semiconductor devices, methods of manufacturing the semiconductor devices, and the electronic apparatuses including the semiconductor devices described above, have been described with reference to the embodiments illustrated in the drawings, these are merely examples, and those skilled in the art will understand that various modifications and equivalent other embodiments may be possible therefrom. Therefore, the embodiments disclosed herein may be considered in an illustrative rather than a restrictive sense. The scope of the rights is indicated in the claims, not in the foregoing description, and all differences within the equivalent scope may be interpreted as being included in the scope of the rights.

The notion that elements are "substantially the same" may indicate that the element may be completely the same and may also indicate that the elements may be determined to be the same in consideration of errors or deviations occurring during a process.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
an active semiconductor layer;
a gate insulating film surrounding at least three surfaces of the active semiconductor layer; and
a gate electrode extending in a first direction and surrounding at least three surfaces of the gate insulating film, wherein
the gate electrode is separated from another gate electrode or another electronic device by a gate cut having a shape of a trench to electrically isolate the gate electrode from the other gate electrode or the other electronic device,
the gate cut faces the gate electrode in a second direction,
the second direction is perpendicular to the first direction, and
the gate insulating film extends to a sidewall of the gate cut along a lower surface of the gate electrode.

2. The semiconductor device of claim 1, further comprising
an isolation film comprising an insulating dielectric material, wherein
the active semiconductor layer extends in the first direction and protrudes from the isolation film in the first direction.

3. The semiconductor device of claim 2, wherein
a first portion of the gate electrode extending along a surface of the active semiconductor layer from an upper surface of the isolation film to surround the active semiconductor layer,
a second portion of the gate electrode extends in the second direction on the upper surface of the isolation film,
a first part of the gate insulating film is between the active semiconductor layer and the first portion of the gate electrode, and
a second part of the gate insulating film is between the upper surface of the isolation film and the second portion of the gate electrode.

4. The semiconductor device of claim 3, wherein a third part of the gate insulating film extends to an outer surface of the gate electrode opposite to the active semiconductor layer through the sidewall of the gate cut, and the first part, the second part, and the third part of the gate insulating film extend continuously; and/or
wherein an end portion of the second portion of the gate electrode matches a position of the gate cut.

5. The semiconductor device of any of claims 2-4, wherein
the gate cut has the shape of the trench provided in an upper surface of the isolation film,
a bottom surface of the gate cut further protrudes in the first direction from the upper surface of the isolation film adjacent to the gate cut in a third direction, and
the third direction is perpendicular to the first direction and the second direction.

6. The semiconductor device of any of claims 1-5, further comprising:
a gate connection portion, wherein
the active semiconductor layer comprises a first active semiconductor layer and a second active semiconductor layer adjacent to each other in the second direction,
the gate electrode comprises a first gate electrode surrounding at least three surfaces of the first active semiconductor layer and a second gate electrode surrounding at least three surfaces of the second active semiconductor layer, and
the gate connection portion is between the first gate electrode and the second gate electrode.

7. The semiconductor device of claim 6, wherein the first gate electrode, the second gate electrode, and the gate connection portion are formed integrally from a single conductive material; and/or
wherein the gate connection portion includes a conductive material having a greater electrical conductivity than a material of the first gate electrode and a material of the second gate electrode.

8. The semiconductor device of claims 6 or 7, wherein
the gate insulating film surrounds at least three surfaces of the first active semiconductor layer between the first active semiconductor layer and the first gate electrode, and
the gate insulating film surrounds at least three surfaces of the second active semiconductor layer between the second active semiconductor layer and the second gate electrode.

9. The semiconductor device of claim 8, wherein the gate insulating film extends along the first gate electrode, the gate connection portion, and the second gate electrode;
preferably wherein
the gate insulating film surrounds a lower surface of the gate connection portion, an upper surface of the gate connection portion, and both side surfaces of the gate connection portion in a third direction, and
the third direction is perpendicular to the first direction and the second direction.

10. The semiconductor device of any of claims 6-9, wherein
the gate connection portion comprises a first gate connection portion adjacent to the first gate electrode and a second gate connection portion adjacent to the second gate electrode, and
a thickness of the first gate connection portion in the first direction is different from a thickness of the second gate connection portion in the first direction;
preferably wherein
the first gate electrode and the second gate electrode comprises a first gate layer and a second gate layer surrounded by the first gate layer,
the first gate connection portion and the second gate connection portion each comprise a first connection layer and a second connection layer surrounded by the first connection layer,
the first gate layer of the first gate electrode, the first gate layer of the second gate electrode, the first connection layer of the first gate connection portion, and the first connection layer of the second gate connection portion each comprise a first conductive material,
the second gate layer of the first gate electrode, the second gate layer of the second gate electrode, the second connection layer of the first gate connection portion, and the second connection layer of the second gate connection portion each comprise a second conductive material,
the second conductive material is different from the first conductive material,
a thickness of the first connection layer of the first gate connection portion is equal to a thickness of the first connection layer of the second gate connection portion, and
a thickness of the second connection layer of the first gate connection portion in the first direction is different from a thickness of the second connection layer of the second gate connection portion in the first direction.

11. The semiconductor device of any of claims 6-10, further comprising an insulating filler covering the gate connection portion between the first gate electrode and the second gate electrode;
a conductive filler on the insulating filler between the first gate electrode and the second gate electrode; and
a gate contact contacting an upper surface of the conductive filler.

12. The semiconductor device of any of claims 6-11, further comprising
a conductive filler covering the gate connection portion between the first gate electrode and the second gate electrode; and
a gate contact contacting an upper surface of the conductive filler.

13. The semiconductor device of any of claims 1-12, wherein
a first portion of the gate insulating film surrounds four surfaces of the active semiconductor layer,
a second portion of the gate insulating film extends to the sidewall of the gate cut along a lower surface of the gate electrode in the second direction,
the first portion of the gate insulating film is separated from the second portion of the gate insulating film, and
the gate electrode surrounds four surfaces of the first portion of the gate insulating film;
preferably wherein
the active semiconductor layer comprises a plurality of channel elements spaced apart from each other in the first direction, and
the first portion of the gate insulating film surrounds surfaces of each of the plurality of channel elements.

14. A method of manufacturing a semiconductor device, the method comprising:
forming an active semiconductor layer that protrudes and extends in a first direction from a substrate;
forming an isolation film covering an upper surface of the substrate and a side surface of the active semiconductor layer;
conformally forming a dummy gate along a surface of the isolation film;
by partially etching the isolation film, forming a trench adjacent to the active semiconductor layer in a second direction, the second direction being perpendicular to the first direction, the trench extending in a third direction, the third direction being perpendicular to the first direction and the second direction;
forming a dummy block, the dummy block covering the trench and the active semiconductor layer;
removing the isolation film on side surfaces of the dummy gate and the active semiconductor layer to expose the active semiconductor layer and form an empty space in the dummy block;
conformally forming a gate insulating film along an inner surface of the dummy block and the side surface of the active semiconductor layer;
forming a gate electrode, by filling a remaining portion of the empty space in the dummy block, which remains after the gate insulating film is formed, with a conductive material; and
removing the dummy block.

15. An electronic apparatus comprising:
a memory; and
a memory controller configured to control the memory to read data from the memory and/or write data to the memory,
wherein at least one of the memory and the memory controller comprises the semiconductor device of any of claims 1-13.
